# EUROPÄISCHE PATENTSCHRIFT

(11) **EP 4 361 725 B1**
(45) Veröffentlichungstag und Bekanntmachung des Hinweises auf die Patenterteilung: **11.11.2026**
(21) Anmeldenummer: 24164507.6
(22) Anmeldetag: 06.07.2020
(51) Int. Cl.: G03F 7/00

(54) **VERFAHREN ZUM ERZEUGEN VON MIKRO- UND/ODER NANOSTRUKTUREN**
METHOD FOR PRODUCING MICRO- AND/OR NANO-STRUCTURES
PROCÉDÉ DE PRODUCTION DE MICRO- ET/OU NANOSTRUCTURES

(43) Veröffentlichungstag der Anmeldung: 01.05.2024
(62) Dokumentnummer(n) der früheren Anmeldung(en) nach Art. 76 EPÜ: 20737009.9 / 4 176 311
(73) Patentinhaber: EV Group E. Thallner GmbH, 4782 St. Florian am Inn (AT)
(72) Erfinder: Dudus, Anna, 4782 St. Florian am Inn (AT); Treiblmayr, Dominik, 4782 St. Florian am Inn (AT)
(74) Vertreter: Schneider, Sascha

(56) Entgegenhaltungen:
- US-A1- 2008 174 046
- US-A1- 2011 217 479
- US-A1- 2016 129 612
- US-A1- 2018 117 805

## Beschreibung

Die Erfindung betrifft ein Verfahren zum Erzeugen von Mikro- und/oder Nanostrukturen.

Im Stand der Technik werden Mikro- und/oder Nanostrukturen entweder photolithographisch und/oder mit Hilfe der Imprintlithographie hergestellt. In den letzten Jahren hat sich vor allem die Imprintlithographie bewährt. Mit Hilfe der Imprintlithographie ist man in der Lage, mikro- und/oder nanometergroße Strukturen mit Hilfe eines Stempels in ein Material zu prägen. Bei dem Material handelt es sich um eine auf ein Substrat aufgebrachte Prägemasse.

Druckschrift offenbart ein Verfahren zum Herstellen eines Halbleiterbauelements, das das Bearbeiten eines Wafers mit einem Zielmaterial umfasst.

Derartige Imprintverfahren haben in den letzten Jahren zunehmend an Bedeutung gewonnen, da sie schneller, effektiver und kostengünstiger durchzuführen sind als viele photolithographische Verfahren.

Nach der Abscheidung der Prägemasse erfolgt eine Ausrichtung des Strukturstempels relativ zum Substrat. Danach nähern sich der Strukturstempel und das Substrat aneinander an. Die Strukturen des Strukturstempels formen sich in der Prägemasse ab. Vor der Entformung des Strukturstempels von der Prägemasse wird diese gehärtet. Die Härtung erfolgt thermisch und/oder mittels elektromagnetischer Strahlung.

Neben modifizierten beziehungsweise erweiterten Mask Alignern existieren auch eigene Imprintanlagen, die auf und für spezielle Ausführungsformen gebaut wurden. Diese Anlagen sind meistens hoch präzise Ausrichtungsanlagen, die einen Stempel mit noch höherer Präzision zum Substrat ausrichten können. Des Weiteren verfügen diese Anlagen über die Möglichkeit zur Erzeugung von Vakuum, haben spezielle Dispenssysteme und Ähnliches.

Die Prägetechniken arbeiten entweder mit harten oder weichen Stempeln. Unter den Prägelithographietechniken wird vor allem die Verwendung von sogenannten weichen (engl.: soft) Stempeln immer beliebter. Der Grund liegt in der leichten Herstellung der Stempel, effizienten Prägevorgängen, sehr guten Oberflächeneigenschaften der jeweiligen Stempelmaterialien, den geringen Herstellungskosten, der Reproduzierbarkeit des Prägeproduktes und vor allem in der Möglichkeit der elastischen Verformung des Stempels während dem Prägen und der Entformung. In der Softlithographie wird ein Stempel aus einem Polymer, insbesondere einem Elastomer mit einer mikrobeziehungsweise nanostrukturierten Oberfläche verwendet, um Strukturen im Bereich von wenigen nm bis >1000 µm herzustellen.

Elastomere Stempel werden als Negativ eines Masters hergestellt. Beim Masterstempel handelt es sich um einen Hartstempel aus Metall, Kunststoff und/oder Keramik, der durch entsprechend aufwendige Prozesse einmalig hergestellt wird. Aus dem Master können dann beliebig viele elastomere Stempel hergestellt werden. Der Elastizitätsmodul von Quarz beträgt ca. 100 GPa. Im Vergleich sind Elastizitätsmodule von Polymeren (harte und weiche Polymere) um bis zu einige Größenordnungen kleiner, daher werden diese im Vergleich zu Quarz als "weich" bezeichnet (Softlithographie). Die elastomeren Stempel ermöglichen einen konformen, gleichmäßigen Kontakt über große Oberflächen. Sie sind relativ leicht von ihrem Masterstempel, sowie von den Prägeprodukten zu trennen. Um eine gute Trennung von Stempel und Substrat zu gewährleisten, hat die Stempeloberfläche eine möglichst niedrige Oberflächenenergie. Oft ist beispielsweise eine Antihaftbeschichtung notwendig oder vorteilhaft.

Zur Durchführung von Softlithographie Prozessen ist es möglich, den elastomeren Stempel durch einen Träger zu unterstützen. Derzeit werden beispielsweise Glasträgersubstrate mit verschiedenen Dicken verwendet. Durch die Verwendung dicker Glassubstrate verliert der elastomere Stempel, zumindest teilweise, seine Flexibilität. Andererseits kann die Flexibilität des Stempels durch die Auswahl des Trägers gesteuert werden. Die Verwendung von starren Trägern erschwert im Allgemeinen das Trennen von Stempel und Substrat nach dem Prägeprozess.

Analog benötigen dünne Substrate gemäß dem Stand-der-Technik ein Trägersubstrat für besseres Handling. Zu den bekannten Softlithographie Verfahren gehören beispielsweise Mikro- und/oder Nanokontaktdrucken (µ/nCP) und Nanoimprint Lithographie (NIL).

Bei der Nanoimprint Lithographie kann die Aushärtung der Prägemasse thermisch oder durch UV-Strahlung erfolgen. In beiden Fällen wird der Strukturstempel in die Prägemasse gepresst. Dabei werden Strukturstempel und Substrat mit Druck zusammengepresst, damit eine hochauflösende Oberflächenstrukturierung durchgeführt werden kann. Beim UV-NIL lässt sich mit geringeren Anpressdrücken arbeiten im Vergleich zur thermischen NIL und der Prozess kann bei Raumtemperatur stattfinden. Die wichtigsten Parameter bei den NIL-Verfahren sind die Temperatur (vor allem bei der thermischen NIL), der Einpressdruck und die Adhäsion zwischen Prägemasse und Strukturstempel.

Weiche sowie auch weniger weiche Stempel, insbesondere elastomere Stempel, können sich während des Nanoimprint-Prozesses durch den angelegten Druck verformen. Diese Verformung ist druckabhängig. Es ist zu erwarten, dass diese Verformungen bei kleineren Strukturen einen stärkeren Einfluss haben und bei weicheren Stempelmaterialien ausgeprägter sind. Die durch Anpressen entstehenden Deformationen beziehungsweise Verzerrungen von Mikro- und Nanostrukturen finden sich in der ausgehärteten Prägemasse am geprägten Substrat wieder und mindern so die Qualität und die Reproduzierbarkeit der Prägeprozesse.

Sind Strukturstempel und/oder das Substrat zu steif, ist ein externer Druck, insbesondere ein Anpressen, notwendig, um einen konformen beziehungsweise lückenlosen Kontakt zwischen Strukturstempel mit Stempelstrukturen und Substrat mit Prägemasse zu erzielen. Im Stand der Technik werden Aktuatoreinrichtungen eingesetzt, die getrennt ansteuerbare beziehungsweise regelbare Aktuatoren zur Beaufschlagung des Strukturstempels und/oder des Substrats mit einer der Übertragung der Stempelstruktur dienenden und orthogonal zur Substrataufnahmefläche resultierenden Kraft aufweisen.

Gerade bei größeren Flächen ist es schwierig den Druck gleichmäßig über die gesamte Kontaktfläche zu verteilen und Unregelmäßigkeiten auszugleichen. Daher kann es beim Prägen zu einer inhomogenen Strukturierung kommen.

Auch eine mögliche Inhomogenität der Stempeloberfläche wirkt sich auf die Qualität des Prägeprozesses aus. Weiter sind Gaseinschlüsse beim Prägen mit Druck und die damit verbundenen Prägedefekte im Stand der Technik bekannt.

Prägedefekte die bei NIL auftreten können sind beispielsweise Risse, ungleichmäßig gefüllte Stempelstrukturen (daher zum Beispiel Lufteinschlüsse), und eine ungleichmäßige Lack-Schichtdicke.

Die weniger verbreitete Kapillarkraft-Lithographie (CFL) gehört auch zu den Softlithographie Verfahren und basiert auf der Nutzung von Kapillarkräften zur Füllung von Stempelstrukturen ohne externen Druck. In Adv. Funct. Mater. (2002) 12: 405-413 wird die CFL ausführlich vom Namensgeber H. H. Lee beschrieben. Dabei wird der elastomere Stempel in konformen Kontakt zum Substrat gebracht. Für ein Füllen der Kavitäten muss allerdings die Prägemasse eine sehr niedrige Viskosität besitzen. Die CFL wird daher bei höheren Temperaturen durchgeführt und/oder der Lösungsmittelanteil in der Prägemasse ist hoch und eine Lösungsmittel-Atmosphäre ist oft notwendig. Als Stempelmaterial bei der CFL kommt fast nur reines PDMS zum Einsatz, da PDMS für Lösungsmittel und für Gase durchlässig ist. Beim Prägen mit dem PDMS-Stempel füllen sich die Kavitäten unter der Wirkung der Kapillarkräfte und das Lösungsmittel aus der Prägemasse kann durch den PDMS-Stempel hindurch diffundieren und entweichen. Als Prägemasse für CFL hat sich das Epoxy-Material SU-8 etabliert. Probleme wie die Quellung von PDMS beim Lösungsmittel-basierten Prozess sowie die starke Ausdehnung beim thermisch-basierten Prozess führen dazu, dass die CFL nur im Labormaßstab durchgeführt wird und keine industrielle Umsetzung mit Imprintanlagen bekannt ist. Weiter wird in CFL die Prägemasse meist thermisch vernetzt.

In der US 7,442,336 B2 wird beispielsweise eine Vorrichtung und ein Verfahren zum Prägen eines Substrats mit einer Prägemasse angegeben, wobei Substrat und Stempel langsam angenähert werden bis zu einem definierten Abstand, so dass sich die Zwischenräume durch Kapillarkräfte mit der Prägemasse füllen. Dabei wird die externe Kraft so gering wie möglich gehalten, abhängig von den Eigenschaften der Prägemasse, der Dicke der zu prägenden Schicht und der Abmessung der Substratoberfläche.

In der US 8,871,048 B2 wird ein flexibler elastomerer Stempel eingesetzt, so dass die externe Anpresskraft so niedrig wie möglich gehalten werden kann.

In der US 2008/174046 A1 wird Kapillarkraft-Lithographie offenbart, zeigt aber kein teilweises Ablösen des Substrats vor dem Aushärten.

Auch die Mikroformung in Kapillaren (MIMIC) nutzt die Kapillarkräfte, um Strukturen mit PDMS-Stempeln herzustellen. In MIMIC wird aber auf ein Substrat ein PDMS-Stempel mit einer Reliefstruktur aufgedrückt. Dadurch entsteht zwischen Stempel und Substrat ein dreidimensionaler strukturierter Hohlraum. Vor dem Stempel wird eine Monomer-Lösung aufgebracht, die dann spontan die Kapillaren befüllt. Nach dem Aushärten kann der Stempel vom Substrat entfernt werden. Es bleibt eine dreidimensionale Struktur des Polymers auf dem Substrat zurück.

Im Stand der Technik ist insbesondere problematisch, dass die elastischen Eigenschaften von Weichstempeln zu Deformationen beziehungsweise Verzerrungen von Mikro- und Nanostrukturen führen. Die durch Anpressen entstehenden Deformationen und Verzerrungen von Mikro- und Nanostrukturen finden sich in der ausgehärteten Prägemasse am geprägten Substrat wieder und mindern so die Qualität und Reproduzierbarkeit der Prägeprozesse.

Weiche Stempel können sich während des Nanoimprint-Prozesses durch den angelegten Druck verformen. Diese Verformung ist insbesondere druckabhängig. Weiter sind Gaseinschlüsse beim Prägen mit Druck und die damit verbundenen Prägedefekte im Stand der Technik bekannt.

Sind Strukturstempel und/oder Substrat zu steif, ist ein externer Druck i.e. Anpressen notwendig, um einen konformen, lückenlosen Kontakt zwischen Strukturstempel und Substrat mit Prägemasse zu erzielen. Dadurch können druckabhängige Verformungen entstehen, die die Qualität der Prägeprozesse mindern.

Es ist daher Aufgabe der vorliegenden Erfindung ein Verfahren aufzuzeigen, welches die im Stand der Technik aufgeführten Nachteile zumindest zum Teil beseitigen, insbesondere vollständig beseitigen.

Diese Aufgabe wird mit den Merkmalen des unabhängigen Anspruchs gelöst.

Dabei ist im Folgenden mit einer Strukturierung und einer Prägung das Erzeugen der Mikro- und/oder Nanostrukturen gemeint. Insbesondere soll bei einer Prägung kein Anpressen erfolgen.

Die Erfindung beschreibt ein Verfahren zum Erzeugen von mikro- und/oder nanometergroßen Strukturen. Der Erfindung liegt unter anderem der Gedanke zugrunde, durch die Verwendung von sehr dünnen, insbesondere flexiblen, Substraten und unter der Ausnutzung der Kapillarkräfte, die für die Erzeugung genannten technischen Probleme zu lösen. Dabei wird nach einer Kontaktierung von Prägemasse und Strukturstempel die Fixierung des Substrates zumindest zum Teil, bevorzugt durch mindestens ein steuerbares Fixierelement, aufgehoben, wodurch bevorzugt der Prägevorgang eingeleitet wird.

Die Erfindung handelt daher insbesondere von einem Verfahren und einer Vorrichtung zur konformen Kontaktierung von Strukturstempel und Prägemasse ohne die Anwendung eines externen Drucks beziehungsweise ohne Anpressen von Strukturstempel und Prägemasse beim Prägevorgang.

Demnach betrifft die Erfindung ein Verfahren zum Erzeugen von Mikro- und/oder Nanostrukturen, mit mindestens den folgenden Schritten mit dem folgenden Ablauf:
a) Fixierung eines Substrats mit einer Prägemasse auf einer Substrataufnahmeeinrichtung,
b) Kontaktierung eines Strukturstempels mit der Prägemasse,
c) Zumindest teilweise Aufhebung der Fixierung des Substrates,
d) Aushärtung der Prägemasse,
f) Entformung der Prägemasse von dem Strukturstempel.

Offenbart wird eine Vorrichtung zur Erzeugung von Mikro- und/oder Nanostrukturen mit dem zuvor beschriebenen Verfahren, wobei ein Substrat mit einer Prägemasse auf einer Substrataufnahmeeinrichtung fixierbar ist, und wobei ein Strukturstempel mit der Prägemasse kontaktierbar ist, und wobei die Fixierung des Substrates zumindest teilweise aufhebbar ist, und wobei die Prägemasse aushärtbar ist, und wobei die Prägemasse von dem Strukturstempel entformbar ist.

Offenbart wird ein Artikel mit Mikro- und/oder Nanostrukturen, wobei die Mikro- und/oder Nanostrukturen mit einem erfindungsgemäßen Verfahren und/oder mit der offenbarten Vorrichtung hergestellt sind.

In einer bevorzugten Ausführungsform der Erfindung ist vorgesehen, dass das Substrat flexibel ist und sich dadurch zumindest teilweise konform an den Strukturstempel, insbesondere nach der Aufhebung der Fixierung beziehungsweise bei der Strukturierung der Prägemasse, anpasst. Das Substrat besitzt insbesondere eine geringe Dicke und/oder besteht aus einem teilweise biegbaren Material, so dass es bei dem Erzeugen vorteilhaft die Struktur des Strukturstempels teilweise übernehmen kann. Dabei kann sich das Substrat auch nicht oder vollständig an den Strukturstempel anpassen. Nach dem Aushärten der Prägemasse bildet das Substrat mit der ausgehärteten Prägemasse insbesondere eine Einheit. Dadurch kann das Substrat vorteilhaft den Prägevorgang unterstützen und Prägefehler vermeiden. Weiterhin kann sich das dünne und flexible Substrat während des Erzeugungsvorgangs verformen. Insbesondere wird das Substrat vorteilhaft durch das Wirken von Kapillarkräften konform an den Strukturstempel herangezogen und dabei verformt. Zusätzlich wird durch die Flexibilität eine bevorzugte gleichmäßige Kontaktierung während der Erzeugung ermöglicht. Dabei ermöglicht die Flexibilität des Substrates vorteilhaft eine schonende und gleichmäßige Prägung ohne Prägefehler. Bei der Aufhebung der Fixierung wird vorteilhaft ein zusätzlicher Freiheitsgrad gewonnen, wodurch das dünne und flexible Substrat, insbesondere durch die Wirkung von Kapillarkräften, gewünscht den Erzeugungsvorgang unterstützt. Dabei ist nach der Aufhebung der Fixierung das Substrat frei auf der Substrataufnahmeeinrichtung. Durch das Heranziehen der Prägemasse und des Substrates an den Strukturstempel ist es auch denkbar, dass das Substrat teilweise oder vollständig von der Substrataufnahmeeinrichtung, insbesondere durch Kapillarkräfte, abgehoben wird. Insbesondere ist durch die Flexibilität des Substartes keine externe Anpresskraft notwendig, um die Struktur auf die Prägemasse übertragen. Auf diese Weise kann das Substrat insbesondere Unregelmäßigkeiten ausgleichen, wodurch die Qualität des Prägeprozesses zusätzlich erhöht wird.

In einer anderen vorteilhaften Ausführungsform der Erfindung ist vorgesehen, dass nach der zumindest teilweisen Aufhebung der Fixierung des Substrates eine zumindest teilweise Ablösung des Substrates von der Substrataufnahmeeinrichtung, insbesondere durch eine Relativbewegung von Substrataufnahmeeinrichtung und dem Substrat und/oder durch eine Relativbewegung von Substrataufnahmeeinrichtung und einer Stempelaufnahmeeinrichtung und/oder durch Kapillarkräfte, erfolgt. Die Ablösung kann insbesondere das Einrichten eines Abstandes zwischen Substrat und Substartaufnahmeeinrichtung zur Folge haben. Es ist jedoch auch denkbar das die Aufhebung der Fixierung keine Ablösung des Substrates beziehungsweise keine Einrichtung eines Abstandes zur Folge hat. Weiterhin ist es auch möglich, dass insbesondere durch Aktuatoren nach der zumindest teilweisen Aufhebung der Fixierung ein Abstand zwischen dem Substrat und der Substrataufnahmeeinrichtung erzeugt wird. Der durch die Aktuatoren eingerichtete Abstand wird dann vorteilhaft an den Prozess, insbesondere an die Materialeigenschaften, angepasst. Dabei bleibt das Substrat, insbesondere durch Oberflächenspannungen und Kapillarkräfte, an der Prägemasse haften beziehungsweise wird an den Strukturstempel herangezogen, wodurch ebenfalls vorteilhaft ein Freiheitsgrad des Substrates geschaffen wird. Entsprechend der Anordnung von Substartaufnahmeeinrichtung zu der Stempelaufnahmeeinrichtung können weitere Kräfte, insbesondere Gravitationskräfte, bei dem Prägevorgang wirken. Insbesondere kann der Abstand teilweise auch bereits bei der Kontaktierung, insbesondere durch ein Ansaugen des Substrates durch die auf die Prägemasse wirkenden Kapillarkräfte, eingerichtet werden. Bevorzugt wird ein Abstand jedoch erst nach der zumindest teilweisen Aufhebung der Fixierung eingerichtet. Durch den Abstand kann vorteilhaft die Reproduzierbarkeit und die Effizienz des Prägevorgangs, insbesondere von mehreren gleichzeitig und/oder parallel ausgeführten Prägeschritten, verbessert werden. Zusätzlich kann sich durch den so gewonnen Freiheitsgrad das Substrat verformen und an den Strukturstempel anpassen. Dadurch können insbesondere Prägefehler vermieden werden.

In einer anderen vorteilhaften Ausführungsform der Erfindung ist vorgesehen, dass der Strukturstempel ein Hartstempel oder ein Weichstempel ist. Insbesondere kann der Strukturstempel eine weiche oder harte Prägestruktur aufweisen. Mit einem Hartstempel ist insbesondere ein Masterstempel gemeint. Mit dem Erzeugungsverfahren können somit effizient und kostengünstig, insbesondere durch eine Auswahl von geeigneten Prozessparametern und technisch sinnvollen Herstellungsmaterialien, Weichstempel sowie Mikro- und/oder Nanostrukturen erzeugt werden. Weiterhin kann durch eine geeignete Auswahl des Strukturstempels eine Verformung des Strukturstempels, insbesondere der Prägestruktur des Strukturstempels, verhindert werden und eine gleichmäßige sowie reproduzierbare Prägung erfolgen.

In einer anderen vorteilhaften Ausführungsform der Erfindung ist vorgesehen, dass die Prägemasse ohne Druck und/oder ohne Anpressen, insbesondere durch Kapillarkräfte, strukturiert wird. Dadurch kann vorteilhaft eine Verformung des Strukturstempels verringert, insbesondere verhindert werden. Weiterhin wird dadurch die Reproduzierbarkeit des Prägeprozesses erhöht und es können Prägefehler vermieden werden. Zusätzlich wird das Verfahren effizienter und kostengünstiger. Die vorteilhafte Erzeugung der Strukturen ohne eine externe Anpresskraft kann vorteilhaft die Materialeigenschaften, wie zum Beispiel Festigkeitswerte oder Oberflächeneigenschaften, der Prägemasse nach der Aushärtung verbessern. Zudem kann das Substrat nach dem Ablösen vorteilhaft gehalten werden. Bei der Erzeugung der Mikro- und/oder Nanostrukturen wird zusätzlich der Vorteil des Verfahrens genutzt, dass je kleiner die Ausmaße der Strukturen sind, desto stärker wirken die Kapillarkräfte. Entsprechen kann das Prägen ohne mechanischen Druck ausgeführt werden, wobei die Prägemasse vorteilhaft von den Strukturen aufgenommen wird und sich dadurch besonders gut an die Strukturen anpassen kann. Vorteilhaft ist bei der Kontaktierung von Prägemasse und Strukturstempel nur ein Berühren beziehungsweise ein Benetzen des Strukturstempels, insbesondere einer Prägestrukturoberfläche, erforderlich.

In einer anderen vorteilhaften Ausführungsform der Erfindung ist vorgesehen, dass das Substrat mit der Prägemasse durch mindestens ein steuerbares und in der Substrataufnahmeeinrichtung angeordnetes Fixierelement, insbesondere durch Vakua und/oder Unterdruck, auf der Substrataufnahmeeinrichtung fixiert wird und/oder durch das mindestens eine steuerbare Fixierelement, insbesondere durch Abschalten des Unterdrucks und/oder durch Erzeugen eines Überdrucks, die Fixierung aufgehoben wird. Das mindestens eine Fixierelement kann das Substrat vorteilhaft auf der Substartaufnahmeeinrichtung fixieren, insbesondere an bestimmten Punkten fixieren. Dabei können Fixierelemente insbesondere Vakuumbahnen sein, die beliebig auf der Substrataufnahmeeinrichtungsoberfläche, insbesondere kreisförmig oder spiralförmig angeordnet beziehungsweise eingelassen sind. Bevorzugt können die Fixierelemente einen Überdruck und/oder Unterdruck erzeugen. Die draus resultierenden Kräfte können insbesondere beliebig auf das Substrat, insbesondere auf der der Substrataufnahmeeinrichtung zugewandten Seite des Substrates, eingebracht werden. Insbesondere kann so beispielsweise auch eine Wölbung des Substrates erzeugt werden. Dabei wird das Substrat beispielsweise am Rand der Substartaufnahmeeinrichtung durch einen Unterdruck fixiert und über andere Fixierelemente ein Überdruck erzeugt, wobei sich das Substrat vorteilhaft insbesondere im Zentrum erhebt. Auf diese Weise kann insbesondere bei der Kontaktierung der Kontaktpunkt eingestellt werden. Zusätzlich kann das mindestens eine Fixierelement durch ein technisch sinnvolles und geregeltes partielles Fixieren beziehungsweise Aufheben der Fixierung vorteilhaft Prägefehler, insbesondere Gaseinschlüsse, vermeiden. Auch können die Fixierelemente bei dem Aufheben der Fixierung das Substrat in einer bestimmten Reihenfolge einzeln und/oder in Gruppen freigeben. Auf diese Weise kann vorteilhaft die Erzeugung der Strukturen initiiert werden, insbesondere in bestimmten Bereichen initiiert werden. Bevorzugt sind die Fixierelemente so ausgebildet, dass ein Entformen des Substartes mit der ausgehärteten Prägemasse vom Strukturstempel durch die Fixierelemente unterstützt werden kann. Durch die Fixierelemente kann vorteilhaft ein Prägevorgang initiiert werden. Bei einem Loslassen beziehungsweise Freigeben des Substrates können insbesondere die Kapillarkräfte vorteilhaft auf die Prägemasse und/oder das Substrat einwirken. Durch die Fixierelemente wird insbesondere eine schonende und gleichmäßige Erzeugung der Strukturen ermöglicht. Zudem ist auch das Entformen des Substartes besonderes schonend und vorteilhaft durchführbar. Bevorzugt weisen die Substartaufnahmeeinrichtung und das Substrat die Form eines Wafers auf.

In einer anderen vorteilhaften Ausführungsform der Erfindung ist vorgesehen, dass die Fixierung des Substrates und die zumindest teilweise Aufhebung der Fixierung des Substrates gesteuert wird, insbesondere durch ein Steuern des mindestens einen steuerbaren Fixierelementes, so dass die Strukturierung der Prägemasse und/oder die Freigabe beziehungsweise die Ablösung des Substrates nach der Kontaktierung des Strukturstempel mit der Prägemasse zu einem bestimmten Zeitpunkt erfolgt. Das mindestens eine Fixierelement wird bevorzugt von einer Steuereinheit angesteuert und nimmt so vorteilhaft Einfluss auf den Zeitpunkt der Aufhebung der Fixierung des Substrates und mithin Einfluss auf die Ablösung beziehungsweise auf den Zeitpunkt der Freigabe des Substartes. Dabei kann insbesondere vorgesehen sein, dass die Aufhebung der Fixierung an unterschiedlichen Stellen durch mehrere steuerbare Fixierelemente eingeleitet wird. Auf diese Weise können insbesondere der Zeitpunkt und der Ort für die Aufhebung der Fixierung vorteilhaft geregelt werden. Die Steuereinheit steuert das mindestens eine Fixierelement bevorzugt abhängig von Werten, insbesondere von Sensoren bereitgestellten Werten, an.

In einer anderen vorteilhaften Ausführungsform der Erfindung ist vorgesehen, dass der Strukturstempel so ausgebildet ist, dass nach der zumindest teilweisen Aufhebung der Fixierung die Prägemasse und/oder das Substrat konform an den Strukturstempel ohne externen Druck, insbesondere durch Kapillarkräfte, angepasst beziehungsweise herangezogen werden. Der Strukturstempel, insbesondere die Prägestruktur des Strukturstempels, ist so ausgebildet, dass die Strukturen vorteilhaft, insbesondere durch Kapillarkräfte, auf die Prägemasse übertragen werden. Dabei sind insbesondere die Kontaktflächen des Strukturstempels, welche bei der Kontaktierung die Prägemasse berühren, so ausgebildet, dass ein gleichmäßiges und insbesondere vollflächiges Kontaktieren möglich ist. Vorteilhaft sind die Strukturen beziehungsweise Ausnehmungen und/oder Versprünge der Prägestrukturen des Strukturstempels so angeordnet, dass die Strukturierung ohne Druck erfolgen kann. Insbesondere sind die zu übertragenden Prägestrukturen so ausgebildet, dass sich nach einer Aufhebung der Fixierung das Substrat konform an die Strukturen anpassen kann. Vorteilhaft ist der Strukturstempel auch für ein vorteilhaft leichtes Entformen ausgelegt. Insbesondere kann der Strukturstempel beziehungsweise die Prägestruktur mehrfach verwendet werden. Folglich kann der Erzeugungsprozess effizient und mehrfach hintereinander bei Verwendung desselben Strukturstempels durchgeführt werden.

In einer anderen vorteilhaften Ausführungsform der Erfindung ist vorgesehen, dass das Substrat von der Prägemasse, insbesondere durch Kapillarkräfte und/oder Oberflächenspannungen, nach der Kontaktierung und/oder nach der zumindest teilweisen Aufhebung der Fixierung, gehalten wird. Das Substrat haftet somit zumindest zum Teil nach der Aufhebung der Fixierung durch die Prägemasse an dem Strukturstempel. Dabei kann es, insbesondere durch die auf die Prägemasse wirkenden Kapillarkräfte zu einem Ablösen des Substrates von der Substrataufnahmeeinrichtung kommen. Durch das Freigeben des Substrates beziehungsweise durch die Aufhebung der Fixierung wird das Substrat weiterhin gehalten, wobei sich das Substrat vorteilhaft an den Strukturstempel anpassen kann. Insbesondere kann sich das Substrat vorteilhaft frei und gleichmäßig an die Prägestruktur anpassen. Zudem können auf diese Weise Unregelmäßigkeiten ausgeglichen werden. Eventuell vorhandene Gaseinschlüsse können insbesondere entweichen. Vorteilhaft wird so die Qualität des Prägeprozesses erhöht.

In einer anderen vorteilhaften Ausführungsform der Erfindung ist vorgesehen, dass die Mikro- und/oder Nanostrukturen in mehreren Schichten übereinander und/oder in einem Step-and-Repeat-Verfahren nebeneinander hergestellt werden. Dabei wird ein Mehrschichtaufbau insbesondere so häufig durchgeführt, bis die minimal notwendige Flexibilität des Substrates nicht mehr gegeben ist. Auf diese Weise kann das Verfahren effizienter und kostengünstiger durchgeführt werden. Weiterhin können unterschiedliche Schichten übereinander erzeugt werden. Zusätzlich können mehrere Funktionale Strukturen großflächig oder in einem stetigen Prägeprozess nebeneinander hergestellt werden. Auf diese Weise können mit dem Verfahren verschiedenste Produkte, insbesondere Strukturfolien, effizient hergestellt werden. Insbesondere ist dabei vorteilhaft, dass der Strukturstempel mehrfach benutzt werden kann, da ohne einen Anpressdruck die Beständigkeit des Strukturstempels erhöht wird beziehungsweise der Strukturstempel über mehrere Prägeschritte verwendet werden kann.

In einer anderen vorteilhaften Ausführungsform der Erfindung ist vorgesehen, dass die Dicke des Substrats zwischen 1 µm und 2000 µm, mit Vorzug zwischen 10 µm und 750 µm, mit größerem Vorzug zwischen 100 µm und 500 µm liegt. Durch das Verwenden von dünneren Substraten kann die Flexibilität des Substrates erhöht werden. Somit kann sich das Substrat noch besser an die Prägestruktur anpassen und Unregelmäßigkeiten ausgleichen. Weiterhin können eine größere Anzahl an Schichten übereinander erzeugt werden, da die notwendige Flexibilität über mehr Prägeschritte hinweg bereitgestellt wird.

In einer anderen vorteilhaften Ausführungsform der Erfindung ist vorgesehen, dass die Viskosität der Prägemasse kleiner als 100000 cP, mit Vorzug kleiner als 10000 cP, mit größerem Vorzug kleiner als 1000 cP, mit größtem Vorzug kleiner als 500 cP beträgt. Dabei ist 1 cP= 1 mPas. Durch die Verwendung einer Prägemasse mit einem geringeren cP-Wert können insbesondere das Halten des Substrates, die Wirkung der Kapillarkräfte und das konforme Anpassen an die Prägestrukturen von Substrat und/oder Prägemasse verbessert werden. Weiterhin ist ein niedriger cP-Wert für das Ausgleichen von Unregelmäßigkeiten vorteilhaft. Zudem werden die Flexibilität des Substrates optimal ausgenutzt und dadurch eine erhöhte Prägequalität erzielt. Durch eine geeignete Viskosität der Prägemasse kann insbesondere das Prägeverhalten der Prägemasse und das Halten des Substrates vorteilhaft eingestellt werden.

In einer anderen vorteilhaften Ausführungsform der Erfindung ist vorgesehen, dass der Strukturstempel eine Prägestruktur aufweist und/oder mit einer Prägestruktur beschichtet ist. Der Prägestempel kann also selber die Prägestruktur aufweisen oder mit einer Prägestruktur, insbesondere individuell auf den Prägeprozess angepassten, beschichtet sein. Dadurch kann vorteilhaft das Prägeverhalten eingestellt werden. Insbesondere ist das Erzeugen der Strukturen individuell an den Prozess durch unterschiedliche Prägebeschichtungen einstellbar. Unterschiedliche Prägestrukturen können beispielsweise mit einem Prägestempel übertragen werden, insbesondere in einem Step-and-Repeat Prozess.

In einer anderen vorteilhaften Ausführungsform der Erfindung ist vorgesehen, dass die Vorrichtung zur Erzeugung der Mikro- und/oder Nanostrukturen, insbesondere das zuvor beschriebene Verfahren durchführen kann, wobei ein Substrat mit einer Prägemasse auf einer Substrataufnahmeeinrichtung fixierbar ist, und wobei einen Strukturstempel mit der Prägemasse kontaktierbar ist, und wobei die Fixierung des Substrates zumindest teilweise aufhebbar ist, und wobei die Prägemasse aushärtbar ist, und wobei die Prägemasse von dem Strukturstempel entformbar ist. Dabei kann die Vorrichtung vorteilhaft die Mikro- und/oder Nanostrukturen, insbesondere ohne ein zusätzliche Anpresskraft, erzeugen. Dadurch wird die Qualität des Prägeprozesses erhöht.

In einer anderen vorteilhaften Ausführungsform der Erfindung ist vorgesehen, dass die Vorrichtung weiterhin umfasst: Einen oder mehrere Sensoren zum Messen von Druck, Abständen und/oder Temperaturen, und/oder einen oder mehrere Aktuatoren zum Verstellen der Stempelaufnahmeeinrichtung und/oder der Substrataufnahmeeinrichtung und eine Steuereinheit, wobei die Steuereinheit das mindestens eine Fixierelemente und/oder den mindestens einen Aktuator, insbesondere in Abhängigkeit von einem von dem mindestens einen Sensor gemessenen Wert, steuert, wobei eine Relativbewegung von Strukturstempel zu dem Substrat mit der Prägemasse, insbesondere das Entrichten oder das Verringern eines Abstandes zwischen dem Strukturstempel und dem Substrat, so ausführbar ist, dass eine Kontaktierung, insbesondere ohne Druck, durchführbar ist. Dabei ist insbesondere vorgesehen, dass die Steuereinheit auf Grundlage der Sensorwerte ein Berühren der Strukturstempeloberfläche, insbesondere der Prägestrukturoberfläche, durch Ansteuern der Aktuatoren bewirkt. Dadurch kann vorteilhaft eine Kontaktierung ohne ein zusätzliches Anpressen erfolgen. Dabei können die Aktuatoren zum Einrichten des Abstandes an beliebigen Bauteilen, bevorzugt an Substrataufnahmeeinrichtung und/oder an Stempelaufnahmeeinrichtung, angeordnet sein beziehungsweise angreifen. Auf diese Weise kann vorteilhaft sichergestellt werden, dass die Erzeugung der Mikro- und/oder Nanostrukturen optimal durchgeführt wird. Zusätzlich ist die Steuereinheit so eingerichtet, dass die Fixierung des Substrates durch die Fixierelemente beim Ablösen und beim Entformen, insbesondere abhängig von den Sensorwerten, vorteilhaft ausgeführt werden. Dies hat den Vorteil, dass die Prozessqualität erhöht wird und Prägefehler vermieden werden können.

In einer weniger bevorzugten Ausführungsform der Erfindung ist vorgesehen, dass die Steuereinheit der Vorrichtung durch Ansteuern der getrennt regelbaren Aktuatoren eine Kontaktierung mit zusätzlichem Anpressen bewirkt. Die resultierende Kraft zur Übertragung der Stempelstruktur orthogonal zur Substrataufnahmefläche ist < 500 N. Der Strukturstempel kann beispielsweise vollflächig im Wafer-Format oder alternativ insbesondere in einem Step-and-Repeat Prozess eine definierte Fläche besitzen, die kleiner als das zu prägende Substrat ist. Der resultierende Druck zur Übertragung der Stempelstruktur orthogonal zur Substrataufnahmefläche ist insbesondere kleiner als 50 N/mm2, mit Vorzug kleiner als 25 N/mm2, mit größerem Vorzug kleiner als 10 N/mm2, mit größtem Vorzug kleiner als 1 N/mm2, mit allergrößtem Vorzug kleiner als 0,1 N/mm2.

In der vorliegenden Erfindung ist das Substrat sehr dünn im Vergleich zu den im Stand der Technik beschriebenen Substraten. Entweder wird kein Trägersubstrat zur Stabilisierung des Substrats (beziehungsweise Produktsubstrats) verwendet oder das Trägersubstrat beziehungsweise die Trägerplatte oder Trägerfolie ist selbst dünn und flexibel. Dadurch ist das zu prägende Substrat sehr flexibel, insbesondere flexibel gelagert.

Der Mikro- und/oder Nanoimprint Prozess wird mit einem Strukturstempel, bevorzugt einem elastomeren Strukturstempel, bevorzugt mit einem Strukturstempel im Wafer-Format, durchgeführt. Dabei wird der strukturierte Stempel mit einem bevorzugt vollflächig vorbelackten Substrat kontaktiert, insbesondere mit der auf dem Substrat bereitgestellten Prägemasse kontaktiert.

Strukturstempel und Substrat sind jeweils an einer Aufnahmeeinrichtung einer Imprintanlage fixiert. Die Fixierung vom Substrat an der Substrataufnahmeeinrichtung erfolgt bevorzugt mit Hilfe von Vakuum beziehungsweise Unterdruck. Nach einer Ausrichtung werden die Kontaktflächen von Substrat und Strukturstempel vollflächig kontaktiert. Sobald der Strukturstempel in Kontakt mit dem Substrat ist, wird die Fixierung vom mit Prägemasse beschichteten Substrat insbesondere durch Unterbrechung des Vakuums gelöst. Durch die Wirkung von Kapillarkräften wird das dünne, flexible Substrat konform an den Strukturstempel herangezogen. Durch die Flexibilität des Substrats und den gewonnenen Freiheitsgrad durch das Loslösen des Substrats kann sich das Substrat verformen und an den Strukturstempel anpassen. Dadurch wird eine gleichmäßige Kontaktierung während der Prägung ermöglicht.

Substrat und Strukturstempel werden mit der dazwischenliegenden Prägemasse durch Kapillarkräfte zusammengehalten. Dafür muss mindestens das Substrat, bevorzugt Substrat und Strukturstempel, eine hohe Flexibilität aufweisen. Auf Grund der Viskosität der Prägemasse werden auch durch Kapillarwirkung die Zwischenräume des Strukturstempels insbesondere vollständig damit ausgefüllt.

Durch die Ausnutzung der Kapillarkräfte ist kein zusätzlicher externer Druck beziehungsweise kein Anpressen von Substrat und Strukturstempel beim Prägen beziehungsweise Erzeugen der Mikro- und oder Nanostrukturen notwendig. Dadurch wird eine durch Anpressen verursachte Verformung der Strukturen des Strukturstempels vermieden, insbesondere verhindert.

Mit Kapillarkräften sind insbesondere die Kräfte gemeint, welche durch Oberflächenspannungen und/oder Grenzflächenspannungen entstehen. Insbesondere kann bei der Erzeugung die Kapillaraszension und die Kapillardepression genutzt werden. Auch weitere Kräfte können bei der Erzeugung auftreten, beispielsweise Adhäsionskräfte oder Gewichtskräfte. Dabei kann durch die kleinen Mikro- und/oder Nanostrukturen vorteilhaft ausgenutzt werden, dass je kleiner die Ausmaße der Strukturen sind, desto größer ist die Wirkung der Kapillarkraft beziehungsweise des Kapillardrucks.

Die Flexibilität des Substrats ermöglicht Unregelmäßigkeiten des Strukturstempels und/oder des Substrats auszugleichen und auch weitere Prägedefekte, beispielsweise solche die durch Lufteinschlüsse verursacht werden, zu verhindern, wodurch die Qualität des Prägeprozesses sehr hoch ist.

Durch die Ausnützung der Kapillarkräfte ist insbesondere kein zusätzlicher, externer Druck beziehungsweise kein Anpressen von Substrat und Stempel beim Prägen notwendig. Dadurch werden die Vorrichtung und der Prägeprozess vorteilhaft vereinfacht da keine Aktuatoreinrichtung zur Kraftübertragung notwendig ist.

Durch die Flexibilität des Substrats und den erhaltenen Freiheitsgrad durch das Loslösen des Substrats nach der Kontaktierung ohne externen Druck kann sich das Substrat verformen und sich insbesondere an den Strukturstempel anpassen.

Eine gleichmäßige, konforme Kontaktierung während der Prägung ist möglich. Dadurch werden sehr gute Imprinte erzielt ohne Vorhandensein von Prägelücken, die durch nicht- oder schlecht-kontaktierte Zonen beim Prägen und anschließendem Aushärten entstehen würden.

Die vorgeschlagene Erfindung verhindert eine durch Anpressen verursachte Verformung der Mikro- und/oder Nanostrukturen des Strukturstempels.

Die Viskosität der Prägemasse liegt bevorzugt zwischen 1 und 100000 cP, so dass eine breite Auswahl an Prägematerialien beziehungsweise Prägelacke und eine Prozessoptimierung mit optimaler Kombination von Substrat, Stempelmaterial und Prägematerial möglich ist.

Die Prägemasse muss insbesondere keine niedrige Viskosität besitzen. Es ist insbesondere keine Lösungsmittel-Atmosphäre notwendig.

Das Kontaktieren und Prägen kann insbesondere bei Umgebungsdruck, beispielsweise unter Luft- oder Inertgasatmosphäre durchgeführt werden. Andere, insbesondere regelbare Prozessdrücke sind auch denkbar.

Das Kontaktieren und Prägen kann insbesondere bei Raumtemperatur sowie bei erhöhten Temperaturen durchgeführt werden.

Das beschriebene Verfahren ermöglicht vorteilhaft einen hohen Durchsatz und kann insbesondere die Stückkosten pro hergestellter Einheit senken.

Das Prägen von periodischen und nicht-periodischen Mikro- und Nanostrukturen ist möglich.

Eine präzise Ausrichtung ist vorteilhaft nicht zwingend notwendig. Der Grad der Ausrichtung von Substrat und Strukturstempel vor dem Kontaktieren, beispielsweise nur grob oder fein mit hoch präzise Ausrichtungsanlagen, kann Fallspezifisch variiert werden.

In der dem beschriebenen Verfahren können verschiedene Arten von flexiblen Substraten eingesetzt werden.

Das Prägen beziehungsweise Erzeugen kann mit glatten und/oder mit rauen Oberflächen durchgeführt werden. Die Rauigkeit kann Fallspezifisch variieren.

Das Prägen beziehungsweise Erzeugen kann insbesondere mit flachen und/oder mit gekrümmten Stempeloberflächen durchgeführt werden. Durch die Flexibilität des Substrats und die Beweglichkeit durch das Loslösen des Substrats nach der Kontaktierung ohne externen Druck kann sich das Substrat verformen und an den Stempel anpassen.

Es können sowohl leitende als auch nicht-leitende, mit UV-aushärtbare Prägemassen eingesetzt werden.

Auch können sowohl leitende als auch nicht-leitende, thermisch-aushärtbare Prägemassen eingesetzt werden.

Mit der vorgeschlagenen Erfindung können Mehrschicht-Prägeprozesse durchgeführt werden. Eine erste bereits geprägte und ausgehärtete Schicht auf einem flexiblen Substrat kann in einem weiteren Schritt nochmals mit einer zweiten Prägemasse beschichtet werden, die dann wieder geprägt und ausgehärtet wird. Das Erzeugen weiterer Schichten ist insbesondere solange denkbar, wie eine ausreichende Substratflexibilität noch gegeben ist. Weiterhin können auch mehrere Prägeschritte parallel und/oder nebeneinander durchgeführt werden, sowie mit den jeweils zuvor erzeugen Substraten verbunden werden.

Bei dem beschriebenen Verfahren kann die Dicke der Prägemasse auf dem Substrat nach Bedarf variiert werden, so dass sowohl dünne als auch dickere Schichten aus Prägemasse geprägt beziehungsweise Erzeugt werden können.

Mit der vorgeschlagenen Erfindung können insbesondere sowohl Arbeitsstempel für die Imprintlithographie hergestellt werden als auch allgemein verschiedene Arten von thermisch oder mittels elektromagnetischer Strahlung, insbesondere UV-Strahlung, aushärtbare Prägemassen für die Strukturierung von Substraten geprägt werden. Bevorzugt werden UV-aushärtbare Prägemassen verwendet.

Die vorgeschlagene Erfindung kann insbesondere für die Herstellung folgender Produkte eingesetzt werden:
- 1D-, 2D-, und/oder 3D-diffraktive optische Elemente (DOE),
- mikrofluidische Baugruppen,
- Linsen und Linsensysteme,
- Fresnel-Linsen,
- Biomedizinische Elemente,
- Polarisatoren,
- nanostrukturierte Elektroden,
- IR-Wellenleiter,
- Winkeloptik für virtuelle Realität Anwendungen,
- Glasfaseranschlüsse,
- Arbeitsstempel für Imprintlithographie
- Und Weitere.

Kapillareffekte werden insbesondere durch die Oberflächenspannung von Flüssigkeiten selbst und die Grenzflächenspannung zwischen Flüssigkeiten und der festen Oberfläche hervorgerufen. Bei Wechselwirkungen zwischen festen Oberflächen und Flüssigkeiten oder zwischen festen Körpern in Anwesenheit von insbesondere geringen Flüssigkeitsmengen kommen die Kapillarkräfte zum Vorschein. Die Kohäsion zwischen Flüssigkeitsmolekülen und die Adhäsion zwischen Flüssigkeitsmolekülen und den Oberflächen von Substrat und Strukturstempel durch die dazwischenliegende Beschichtung mit einer Prägemasse tragen dazu bei, dass beide Oberflächen nach Kontaktierung insbesondere ohne Einwirkung von externer Kraft in Kontakt bleiben. Vorteilhaft werden dünne, flexible Substrate verwendet, so dass die Kapillarkräfte entsprechend stark wirken und das Substrat konform an den Strukturstempel herangezogen wird.

Ein weiterer Aspekt ist das Loslassen des dünnen beschichteten Substrats sobald der Strukturstempel in Kontakt mit dem Substrat ist. Die Fixierung vom mit Prägemasse beschichteten Substrat wird insbesondere durch Lösen der Fixierung, beispielsweise durch Unterbrechung des Vakuums, gelöst. Durch die Wirkung von Kapillarkräften bleibt das dünne, flexible Substrat konform mit dem Strukturstempel verbunden.

Durch die Flexibilität des Substrats und dem gewonnenen Freiheitsgrad durch das Loslösen des Substrats von der Substrataufnahmeeinrichtung kann sich das Substrat verformen und an den Strukturstempel anpassen. Dadurch wird eine gleichmäßige Kontaktierung während der Prägung ermöglicht.

Durch den konformen Kontakt werden auf Grund der Viskosität der Prägemasse auch durch Kapillarwirkung die Zwischenräume des Strukturstempels insbesondere vollständig ausgefüllt. Der Kapillardruck ist insbesondere abhängig von der Größe der Strukturen.

Je kleiner die Strukturen, umso größer ist der Kapillardruck. Eine hochauflösende Strukturierung im unteren nm-Bereich (≤ 50 nm) ist möglich, da in diesem Bereich der Kapillardruck am größten ist.

Des Weiteren werden vorteilhaft Prägedefekte verhindert, die durch Anwendung von externem Anpressdruck beim Prägevorgang entstehen würden.

### Verfahren

Das Substrat ist sehr dünn im Vergleich zu Substraten im Stand der Technik. Dabei wird entweder kein Trägersubstrat zur Stabilisierung des Substrats (beziehungsweise Produktsubstrats) verwendet oder das Trägersubstrat beziehungsweise die Trägerplatte oder Trägerfolie ist selbst dünn und flexibel. Dadurch ist das zu prägende Substrat sehr flexibel.

Der Mikro- und/oder Nanoimprint Prozess wird mit einem Strukturstempel, bevorzugt einem elastomeren Stempel, insbesondere im Wafer-Format, durchgeführt. Dabei wird der strukturierte Stempel mit einem bevorzugt vollflächig vorbelackten Substrat kontaktiert.

Strukturstempel und Substrat sind insbesondere jeweils an einer Aufnahmeeinrichtung einer Imprintanlage fixiert. Die Fixierung vom Substrat an der Substrataufnahmeeinrichtung erfolgt bevorzugt mit Hilfe von Vakuum beziehungsweise Unterdruck. Nach einer Ausrichtung werden die Kontaktflächen von Substrat und Strukturstempel vollflächig kontaktiert. Sobald der Strukturstempel in Kontakt mit dem Substrat ist, wird die Fixierung vom mit Prägemasse beschichteten Substrat insbesondere durch Unterbrechung des Vakuums gelöst. Loslöseprozesse können vollflächig oder entlang einer vorgegebenen Strecke wirken. Entsprechend werden die Fixierelemente gesteuert.

Wird das Substrat nach der erfolgten Kontaktierung vollständig von der Aufnahmeeinrichtung gelöst, bleibt das Substrat bedingt durch die zwischen Substrat und Strukturstempel durch die vorhandene Prägemasse wirkende Kapillareffekte (Kapillarkraft) am Strukturstempel haften. Eine zusätzliche externe Anpresskraft ist erfindungsgemäß nicht notwendig für eine erfolgreiche Prägung beziehungsweise Erzeugung.

Durch die Wirkung von Kapillarkräften wird das dünne, flexible Substrat konform an den Stempel herangezogen. Durch die Flexibilität des Substrats und den gewonnenen Freiheitsgrad durch das Loslösen des Substrats kann sich das Substrat verformen und an den Stempel anpassen. Dadurch wird eine gleichmäßige Kontaktierung während der Prägung ermöglicht.

Substrat und Strukturstempel werden mit der dazwischenliegenden Prägemasse durch Kapillarkräfte zusammengehalten. Dafür muss mindestens das Substrat eine hohe Flexibilität aufweisen. Auf Grund der Viskosität der Prägemasse werden durch Kapillarwirkung die Zwischenräume des Strukturstempels insbesondere vollständig damit ausgefüllt.

Die vorgeschlagene Erfindung verhindert dadurch eine durch Anpressen verursachte Verformung der Strukturen des Strukturstempels. Weiterhin ermöglicht die Flexibilität des Substrats Unregelmäßigkeiten des Stempels und/oder des Substrats auszugleichen und auch weitere Prägedefekte, beispielsweise solche die durch Lufteinschlüsse verursacht werden, zu verhindern, wodurch die Qualität des Prägeprozesses sehr hoch ist.

Während dieser Anpassung und Verformung des dünnen Substrats an den Strukturstempel kann das zwischen Substrat und Strukturstempel vorhandene Gas, insbesondere Luft oder Inertgas, rausgedrückt werden, so dass eine Prägung ohne Gaseinschlüsse stattfinden kann. Dabei kann insbesondere durch ein geregeltes Lösen durch die Fixierelemente, die das Substrat halten beziehungsweise fixieren, ein Einschließen von Luft oder anderen Gasen verhindert werden. Dabei kann insbesondere durch ein einzelnes Freigeben der Fixierelemente, insbesondere konzentrisches Freigeben entlang der Waferfläche ein vorteilhaftes Lösen des Substrates erfolgen.

Nach dem Aushärten der Prägemasse kann das Substrat bei Bedarf wieder mit Vakuum an der Aufnahmeeinrichtung fixiert werden, so dass die Entformung stattfinden kann.

Das erfindungsgemäße Verfahren zum Prägen von dünnen, flexiblen Substraten mit einem Strukturstempel für die Mikro- und/oder

Nanostrukturierung weist insbesondere folgende Schritte auf, insbesondere in der folgenden Reihenfolge:
a) Fixierung von Substrat und Strukturstempel an den entsprechenden Aufnahmeeinrichtungen;
b) Aufbringung der Prägemasse auf das Substrat;
c) Grob- und/oder Feinjustierung von Substrat und Strukturstempel;
d) Prägeprozess starten durch Kontaktierung, insbesondere durch eine Relativbewegung der Substrataufnahmeeinrichtung und/oder der Stempelaufnahmeeinrichtung, von Substrat mit Prägemasse und Strukturstempel, so dass durch Kapillareffekte das Substrat am Strukturstempel herangezogen wird und ein konformer Kontakt entsteht.
e) Loslösen der Fixierung vom flexiblen Substrat an der Substrataufnahmeeinrichtung sobald die Kontaktierung erfolgt ist. Durch den so erhaltenen Freiheitsgrad kann sich das flexible Substrat verformen und an den Strukturstempel anpassen.
f) Aushärtung der Prägemasse;
g) Erneute Fixierung des geprägten Substrats an der Substrataufnahmeeinrichtung und Entformen von Strukturstempel und Substrat.

Vorzugsweise wird das Prägen nach einer Kontaktierung der Kontaktflächen von Substrat und Strukturstempel mit Prägemasse und somit nach Einsetzen der Kapillarkräfte insbesondere durch Loslösen des Substrats initiiert.

Das dünne Substrat unterliegt nach dem Loslösen insbesondere keiner Fixierung an der Aufnahmeeinrichtung mehr und kann sich somit an den Strukturstempel anpassen.

Bevorzugt wird mit Kontaktierung eine vollflächige Kontaktierung beschrieben. Alternativ kann die Kontaktierung vom Rand her oder von der Mitte her stattfinden. Für eine punktförmige Kontaktierung wird in einer weiteren Ausführungsform der Strukturstempel und/oder das Substrat mittels Krümmungsmitteln gekrümmt. Vorteilhaft kann die Kontaktierung durch insbesondere geregelte Fixierelemente unterstützt werden.

In einer anderen Ausführungsform wird ein step-and-repeat Prozess durchgeführt. Dabei wird der Strukturstempel im step-and-repeat Verfahren so eingesetzt, dass eine sich wiederholende Struktur am Umfang beispielsweise einer Prägerolle aufgebracht wird. Dabei ist vorgesehen, dass die Vorrichtung Aushärtemittel zum, insbesondere abschnittsweisen, vorzugsweise mit dem step-and-repeat-Verfahren entsprechenden, insbesondere einer Stempelfläche des Strukturstempels korrespondierenden Abschnitten, Aushärten des geprägten Substrats aufweist.

### Substrat, Strukturstempel und Prägemasse

Besonders bevorzugt ist das Substrat und/oder der Strukturstempel flexibel, um einen konformen Kontakt über die gesamte Substrat- beziehungsweise Strukturstempeloberfläche zu ermöglichen. In einer bevorzugten Ausführungsform ist das Substrat sehr dünn, so dass eine vorteilhafte Flexibilität gegeben ist. Entweder wird kein Trägersubstrat zur Stabilisierung des Substrats verwendet oder das Trägersubstrat beziehungsweise die Trägerplatte oder Trägerfolie ist auch selbst dünn und flexibel. Dadurch ist das zu prägende Substrat sehr flexibel. Das dünne Substrat ist an einer Aufnahmeeinrichtung fixiert, so dass die Handhabung erleichtert wird.

Das Substrat kann jede Form haben, mit Vorzug rund, rechteckig oder quadratisch, mit größerem Vorzug im Wafer Format. Der Durchmesser der Substrate beträgt mehr als 2 Zoll, mit Vorzug mehr als 4 Zoll, mit größerem Vorzug mehr als 6 Zoll, mit noch größerem Vorzug mehr als 8 Zoll, mit größtem Vorzug mehr als 12 Zoll. Unter einem Substrat wird insbesondere ein Wafer verstanden. Dabei ist 1 Zoll = 25,4 mm; bei Waferdurchmessern wird im Allgemeinen abgerundet auf 25 mm, so dass die genannten Durchmesser üblicherweise 50 mm, 100 mm, 150 mm, 200 mm oder 300 mm entsprechen.

Die Dicke des Substrats liegt insbesondere zwischen 1 µm und 2000 µm, mit Vorzug zwischen 10 µm und 750 µm, mit größerem Vorzug zwischen 100 µm und 500 µm.

Der Strukturstempel kann jede Form haben, mit Vorzug rund, rechteckig oder quadratisch, mit größerem Vorzug im Wafer-Format. Der Durchmesser der Strukturstempel stimmt vorzugsweise weitgehend mit dem Durchmesser der Substrate überein.

Zur Realisierung von Softlithographie Prozessen werden standardgemäß elastomere Strukturstempel verwendet, mit Vorzug sind es UV-transparente Polymer-Stempel.

Transparente elastomere Strukturstempel für UV-NIL werden beispielsweise aus den folgenden Polymeren hergestellt: Silikone wie Polydimethylsiloxan (PDMS), Polyorganosilsesquioxane (POSS), perfluorierte Polyether (PFPE), Polytetrafluorethylen (PTFE), Polyvinylalkohol (PVA), Polyvinylchlorid (PVC), Ethylentetrafluorethylen, und so weiter. Kombinationen von mehreren Materialien sowie mehreren Schichtsystemen sind möglich.

Der Strukturstempel wird vorzugsweise auf einem Träger (engl.: backplane), insbesondere einer Platte, am bevorzugtesten einem Glasträger, fixiert. Weitere denkbare Materialien für den Träger sind Polymere und/oder Metalle. Der Träger kann insbesondere auch ein Stempelträgersubstrat sein.

Der Strukturstempel besitzt an seiner Prägeseite, insbesondere mehrere, bevorzugt über die gesamte Prägefläche der Prägeseite verteilte, insbesondere regelmäßig angeordnete, Prägestrukturen. Die Abmessungen der einzelnen Strukturen des Prägestempels liegen vorzugsweise im Mikrometer- und/oder im Nanometerbereich. Die Abmessungen der einzelnen Strukturen sind insbesondere kleiner als 20 µm. Die Abmessungen der einzelnen Strukturen liegen insbesondere zwischen 0,1 nm und 20 µm, mit Vorzug zwischen 1 nm und 10 µm, mit größerem Vorzug zwischen 1 nm und 5 µm, mit noch größerem Vorzug zwischen 1 nm und 2 µm.

Der Strukturstempel kann eine, der zu behandelnden Substratoberfläche zugewandten Seite befindliche, positive und/oder negative Profilierung aufweisen. Der Strukturstempel kann auch Prägestrukturen mit unterschiedlichen Abmessungen aufweisen.

In einer alternativen Ausführungsform ist der Strukturstempel aus harten UV-transparenten Materialien wie beispielsweise Glas, Quarz, oder Siliziumdioxid. In dieser Ausführungsform muss insbesondere das Substrat die erforderliche dünne Schichtdicke und Flexibilität aufweisen. In einer weiteren Ausführungsform ist der Strukturstempel aus harten Materialien wie beispielsweise Silizium, Halbleitermaterialien, oder Metalle wie Ni oder Ti.

Die Prägemasse wird insbesondere durch chemische und/oder physikalische Vorgänge ausgehärtet. Insbesondere wird die Prägemasse durch elektromagnetische Strahlung und/oder durch Temperatur ausgehärtet.

Mit Vorzug erfolgt die Aushärtung durch elektromagnetische Strahlung, mit besonderem Vorzug durch UV-Strahlung. In diesem Fall ist der Strukturstempel bevorzugt transparent für die notwendige elektromagnetische Strahlung, wenn die Prägemasse von der Strukturstempelseite her ausgehärtet werden soll.

An der von den Prägestrukturen abgewandten Seite vom Strukturstempel ist bevorzugt eine entsprechende Strahlungsquelle angeordnet. Der Strukturstempel ist daher insbesondere transparent in einem Wellenlängenbereich zwischen 5000 nm und 10 nm, mit Vorzug zwischen 1000 nm und 100 nm, mit größerem Vorzug zwischen 700 nm und 200 nm, mit größtem Vorzug zwischen 500 nm und 250 nm.

Die optische Transparenz des Strukturstempels ist dabei größer als 0,01%, mit Vorzug größer als 20%, mit größerem Vorzug größer als 50%, mit größtem Vorzug größer als 80%, mit allergrößtem Vorzug größer als 95%.

Die Viskosität der Prägemasse liegt bevorzugt zwischen 1 und 100000 cP, so dass eine breite Auswahl an Prägematerialien/Prägelacken und eine Prozessoptimierung mit optimaler Kombination von Substrat, Stempelmaterial und Prägematerial möglich ist. Die Viskosität ist insbesondere kleiner als 100000 cP, mit Vorzug kleiner als 10000 cP, mit größerem Vorzug kleiner als 1000 cP, mit größtem Vorzug kleiner als 500 cP.

Die Prägemasse wird insbesondere vollflächig beschichtet oder als Tropfen in definierten Abständen auf Substrat oder Strukturstempel aufgetragen. Bevorzugt wird die Prägemasse auf das Substrat aufgetragen. Dabei kann das Auftragen der Prägemasse vor oder nach der Fixierung des Substrates erfolgen. Erfindungsgemäß können auch Bereiche mit mehr Prägemasse beziehungsweise mehr Tropfen definiert werden, je nach Topographie des Strukturstempels beziehungsweise je nach Größe der Strukturen. Die Auftragung der Prägemasse kann beispielsweise mit einer Dosiereinrichtung mit einer Düse, die zwischen dem Strukturstempel und das Substrat anordbar ist, durchgeführt werden.

In einer anderen Ausführungsform kann die Erfindung in Kombination mit den etablierten industriellen Belackungsverfahren angewendet werden, wie zum Beispiel dem Spin-Coating Verfahren. Die Belackung kann vom Prägeprozess getrennt in einem eigenen Modul durchgeführt werden. Somit ist das Belacken vom Substrat schnell, defektfrei, vollflächig, frei von Partikel und standardisiert sein. Insbesondere ergeben sich dadurch DurchsatzVorteile und Kostensenkungen.

### Vorrichtung

Die Erfindung betrifft insbesondere das beschriebene Verfahren. Nicht Teil der Erfindung ist eine Vorrichtung zur Übertragung einer Struktur, insbesondere einer Mikro- oder einer Nanostruktur, von einem bevorzugt UV-transparenten Strukturstempel auf eine Flachseite eines insbesondere vollflächigen belackten Substrats mit einem, das Substrat auf einer Substrataufnahmefläche aufnehmenden Substrathalter und einer parallel zur Substrataufnahmefläche ausrichtbaren und gegenüberliegend zu dieser anordnungsbaren Strukturfläche des Strukturstempels.

Die Vorrichtung kann bevorzugt in einer Prozesskammer installiert sein, die zur Umgebung hermetisch abgeschlossen werden kann. Damit werden eine Evakuierung der Prozesskammer und/oder eine Ventilierung der Prozesskammer mit einem beliebigen Gas beziehungsweise Gasgemisch ermöglicht. Die Prozesskammer kann dabei auf Drücke kleiner als 1 bar, mit Vorzug kleiner als 10 mbar, mit größerem Vorzug kleiner als 5 mbar evakuiert werden.

In einer bevorzugten Ausführung findet der erfindungsgemäße Prozess bei Umgebungsdruck, beispielsweise unter Luft- oder Inertgasatmosphäre, statt.

Die Prozesskammer kann insbesondere mit jedem beliebigen Gas beziehungsweise Gasgemisch gespült werden. Das ist vor allem dann vorteilhaft, wenn die Prägung nicht unter Vakuum stattfinden soll. Ein möglicher, aber nicht der einzige, Grund für den Verzicht eines Vakuums wäre eine hohe Flüchtigkeit der Prägemasse bei niedrigem Umgebungsdruck. Die leichte Flüchtigkeit, die durch einen hohen Dampfdruck charakterisiert wird, kann maßgeblich zur Verunreinigung der Prozesskammer beitragen.

Das verwendete Gas sollte dann eine möglichst geringe Wechselwirkung mit der Prägemasse besitzen. Besonders bevorzugt wäre die Spülung mit einem Inertgas, das mit der Prägemasse nicht wechselwirkt.

Das Kontaktieren und Prägen kann sowohl bei Raumtemperatur als auch bei erhöhten Temperaturen durchgeführt werden. Die Anlage besitzt entsprechende Mittel zum Temperieren und Heizen. In einer anderen Ausführungsform ist das Kontaktieren von Substrat und Strukturstempel besonders kritisch, da hier Fehler auftreten können und somit eine reproduzierbare Justiergenauigkeit nicht eingehalten werden kann. Die Vorrichtung kann in Kombination mit Alignment für hochgenaues, justiertes Prägen u.a. von verschiedenen Lagen übereinander zum Beispiel unter Zuhilfenahme des SVA (SmartView^{®} Alignment)-Verfahrens angewendet werden. Bei dem kritischen Schritt der Kontaktierung der ausgerichteten Kontaktflächen von Substrat und (Nano-)Strukturstempel ist eine immer exaktere Justiergenauigkeit beziehungsweise Offset von weniger als 100 µm gewünscht, insbesondere weniger als 10 µm, vorzugsweise weniger als 1 µm, mit aller größtem Vorzug kleiner als 100 nm, am bevorzugtesten weniger als 10 nm.

Bei der beschriebenen Vorrichtung werden Substrat und Strukturstempel ausgerichtet zusammengeführt, so dass Annäherung und Justierung für einen mikro- und/oder nanoimprint Prägeprozess kontrolliert durchgeführt werden. Die Vorrichtung verfügt vorzugsweise über ein System für einen kontaktlosen Keilfehlerausgleich zwischen dem parallel ausgerichteten Stempel und dem Substrat gemäß der Patentdruckschrift EP2612109B1, wobei Annäherungsmittel zur Annäherung einer ersten Oberfläche zu einer zweiten Oberfläche in einer Translationsrichtung (T) quer zu den Aufnahmeflächen der Aufnahmeeinrichtungen bis in eine Endposition eingesetzt werden.

In einer anderen Ausführungsform ist eine grobe Ausrichtung ausreichend. Eine exakte Ausrichtung ist insbesondere nicht erforderlich da sich das dünne Substrat, durch seine Flexibilität und die gegebene Beweglichkeit durch das Loslösen von der Substrataufnahme, an den Strukturstempel anpassen kann.

Substrat und Strukturstempel werden an einer Aufnahmeeinrichtung (engl.: chuck) fixiert. Entscheidend für die Aufnahmeeinrichtung ist insbesondere eine ebene Aufnahmefläche beziehungsweise Halterungsfläche zur Halterung und Fixierung. Die Aufnahmeeinrichtung für Substrat und Strukturstempel ist mit Vorzug ein Vakuumprobenhalter. Denkbar wäre auch die Verwendung eines elektrostatischen Probenhalters, eines Probenhalters mit magnetischer oder elektrischer Fixierung, ein Probenhalter mit einer veränderbaren Adhäsionseigenschaft oder mit einer entsprechenden mechanischen Klemmung.

In einer bevorzugten Ausführungsform werden Substrat und Strukturstempel auf einer planen gehärteten Oberfläche, in welche Vakuumbahnen gefräst sind, durch Unterdruck beziehungsweise Vakuum fixiert. Die Substrataufnahmeeinrichtung hat Vakuumbahnen auf der gesamten Fläche oder auf Außenzonen der Fläche. Mit Vorteil verläuft der Unterdruckkanal konzentrisch, insbesondere kreisförmig, zu einem Zentrum Z der Aufnahmeeinrichtung, insbesondere vollumfänglich. Hierdurch wird vorteilhaft eine insbesondere gleichmäßige Fixierung erreicht.

Bevorzugt haben die Aufnahmeeinrichtungen, insbesondere die Substrataufnahmeeinrichtung, Vakuumbahnen nur auf Außenzonen der Fläche, so dass das Substrat nur teilweise, insbesondere am Rand fixiert wird. Insbesondere besteht dabei die Möglichkeit, das Substrat und/oder den Strukturstempel vollständig von der Aufnahmeeinrichtung zu lösen. Dazu wird die Fixierung, insbesondere das Haltevakuum, der Aufnahmeeinrichtung deaktiviert. Die Fixierelemente, welche mit Unterdruck zur Fixierung beaufschlagbar sind, können zum Loslösen des Substrats auch mit Überdruck beaufschlagt werden. Die Aufnahmeeinrichtung kann gemäß einer vorteilhaften Ausführungsform über eine zweite Vakuumzone verfügen, um nach dem Präge- und Aushärtevorgang eine vollflächige Fixierung des Substrats zu gewährleisten.

Sind die Fixierelemente als Vakuumelemente vorgesehen, so können Sie einen Druck von weniger als 1bar, vorzugsweise weniger als 0,1 mbar, noch bevorzugter 0,01 mbar, am bevorzugtesten weniger als 0,001 mbar, am allerbevorzugtesten weniger als 0,0001 mbar erzeugen. Die Fixierelemente können insbesondere einzeln oder in Gruppen angesteuert werden.

Eine Aufnahmeeinrichtung kann alternativ oder zusätzlich über Sensoren verfügen, mit deren Hilfe physikalische und/oder chemische Eigenschaften zwischen dem fixierten Substrat und der Aufnahmeeinrichtung vermessen werden können. Diese Sensoren sind beispielsweise Temperatursensoren, Drucksensoren oder Abstandssensoren. Denkbar ist auch, dass mehrere unterschiedliche Sensorarten verbaut werden. Weiterhin können die Sensoren auch an anderen Teilen der Vorrichtung angeordnet sein. Beispielsweise kann ein Abstandssensor oder ein Drucksensor zwischen den Aufnahmeeinrichtungen angeordnet sein. Insbesondere kann der Abstand und/oder eine wirkende Kraft zwischen dem Substrat mit der Prägemasse und dem Stempel beziehungsweise der Stempelstruktur gemessen werden.

Weiterhin kann bei Bedarf die Kontur der Aufnahmefläche gegenüber der Aufnahmeebene der Aufnahmefläche zurückgesetzt sein, so dass Vertiefungen gebildet werden, die die Auflagefläche verkleinern beziehungsweise verändern. Somit können auch beidseitig strukturierte beziehungsweise prozessierte Substrate (Produktsubstrate) eingesetzt werden.

In einer anderen Ausführungsform sind die Aufnahmeeinrichtungen so ausgebildet, dass Substrat und/oder Strukturstempel vollflächig oder abschnittsweise temperiert werden können. Die Aufnahmeeinrichtungen können in einem Temperaturbereich zwischen -100°C und 500°C, vorzugsweise zwischen -50°C und 450°C, noch bevorzugter zwischen -25°C und 400°C, am bevorzugtesten zwischen 0°C und 350°C temperiert werden.

Eine Ausführungsform der Substrataufnahmeeinrichtung ermöglicht außerdem das Handling von Substraten mit flüssiger Schicht drauf. Die flüssige Schicht ist insbesondere ein flüssiger Prägelack beziehungsweise Prägemasse der sich im Interface während des Kontaktierens befindet.

Die Prägemasse wird insbesondere vollflächig beschichtet oder als Tropfen in definierten Abständen auf Substrat oder Strukturstempel aufgetragen. Bevorzugt wird die Prägemasse auf das Substrat aufgetragen. Es können auch Bereiche mit mehr Prägemasse beziehungsweise mehr Tropfen definiert werden, je nach Topographie des Substrats und/oder des Strukturstempels. Die Auftragung der Prägemasse kann insbesondere mit einer Dosiereinrichtung mit einer Düse, die zwischen dem Strukturstempel und das Substrat anordbar ist, durchgeführt werden.

In einer anderen Ausführungsform kann das Verfahren in Kombination mit den etablierten industriellen Belackungsverfahren angewendet werden wie zum Beispiel Spin-Coating Verfahren. Die Belackung kann vom Prägeprozess getrennt in einem eigenen Modul durchgeführt werden. Somit ist das Belacken vom Substrat schnell, defektfrei, vollflächig, frei von Partikel und standardisiert durchführbar. Dies bringt insbesondere auch Durchsatzvorteile mit sich.

In einer anderen Ausführungsform besitzen die Aufnahmeeinrichtungen, vorzugsweise im Zentrum, eine Vorrichtung zum Verbiegen des, insbesondere nur teilweise fixierten Strukturstempels und/oder Substrats. Die Vorrichtung zum Verbiegen wird als Krümmungselement bezeichnet. Das Krümmungselement ist insbesondere eine Düse, durch die ein Fluid, vorzugsweise ein Gas, austreten kann, um einen Überdruck beispielsweise zwischen dem Strukturstempel und der Aufnahmeeinrichtung zu erzeugen, welcher den Strukturstempel krümmt. Indem der Strukturstempel vorzugsweise am Umfang mit der Aufnahmeeinrichtung per Vakuum fixiert wird, ergibt sich eine Krümmung des Strukturstempels.

Erfindungsgemäß wird das Prägen nach einer Kontaktierung, bevorzugt einer vollflächigen Kontaktierung der Kontaktflächen von Substrat und Strukturstempel mit Prägemasse und somit nach Einsetzen der Kapillarkräfte insbesondere durch Loslösen des Substrats initiiert.

Weitere Vorteile, Merkmale und Einzelheiten der Erfindung ergeben sich aus der nachfolgenden Beschreibung bevorzugter Ausführungsbeispiele sowie anhand der Zeichnungen. Die Figuren zeigen Ausführungsformen, die nicht unter die Erfindung fallen. Dabei zeigen schematisch:
Figur 1a: eine Querschnittsansicht der Vorrichtung in einer ersten Ausführungsform des Verfahrens,
Figur 1b: eine Querschnittsansicht der Vorrichtung in der ersten Ausführungsform des Verfahrens nach Annäherung der Strukturstempel- und Substrathalter bis zu einem Endpunkt ohne externe Anpresskraft,
Figur 1c: eine Querschnittsansicht der Vorrichtung in der ersten Ausführungsform des Verfahrens, wobei das Substrat von der Substrataufnahmeeinrichtung durch Unterbrechung von Vakuum in Vakuumbahnen abgelöst wird und durch Kapillarkräfte am Strukturstempel konform haftet,
Figur 1d: eine Querschnittsansicht der Strukturstempel-Aufnahmeeinrichtung in der ersten Ausführungsform des Verfahrens nach dem Prägen beziehungsweise Erzeugen, wobei die aushärtbare Prägemasse im Stapel, insbesondere durch den transparenten Strukturstempel hindurch, mittels UV-Licht vernetzt beziehungsweise ausgehärtet wird,
Figur 1e: eine Querschnittsansicht der Vorrichtung nach dem Prägen, wobei nach erneuter Fixierung des geprägten Substrats an der Substrataufnahmeeinrichtung ein Entformen von Strukturstempel und Substrat stattgefunden hat,
Figur 2: eine Querschnittsansicht der Vorrichtung in einer ersten Ausführungsform des Verfahrens mit einer Vergrößerungsansicht der Querschnittsansicht,
Figur 3a: eine zweite Querschnittsansicht der Vorrichtung in der ersten Ausführungsform des Verfahrens, wobei das Substrat von der Substrataufnahmeeinrichtung durch Unterbrechung von Vakuum in Vakuumbahnen abgelöst wird und durch Kapillarkräfte am Strukturstempel konform haftet,
Figur 3b: eine Querschnittsansicht der Vorrichtung nach dem Prägen, wobei nach erneuter Fixierung des geprägten Substrats an der Substrataufnahmeeinrichtung ein Entformen von Strukturstempel und Substrat stattgefunden hat,
Figur 4a: eine Querschnittsansicht der Vorrichtung in einer zweiten Ausführungsform des erfindungsgemäßen Verfahrens,
Figur 4b: eine Querschnittsansicht der Vorrichtung in der zweiten Ausführungsform des Verfahrens nach Prägung und Aushärtung,
Figur 4c: eine Querschnittsansicht der Vorrichtung in der zweiten Ausführungsform des Verfahrens nach Entformung,
Figur 4d: eine Querschnittsansicht der Vorrichtung in der zweiten Ausführungsform des Verfahrens in einem zweiten Wiederholschritt des step-and-repeat Prägeverfahrens.

In den Figuren sind gleiche Bauteile oder Bauteile mit der gleichen Funktion mit den gleichen Bezugszeichen gekennzeichnet. Die Figuren sind nicht maßstabsgetreu dargestellt, um die Darstellung zu verbessern.

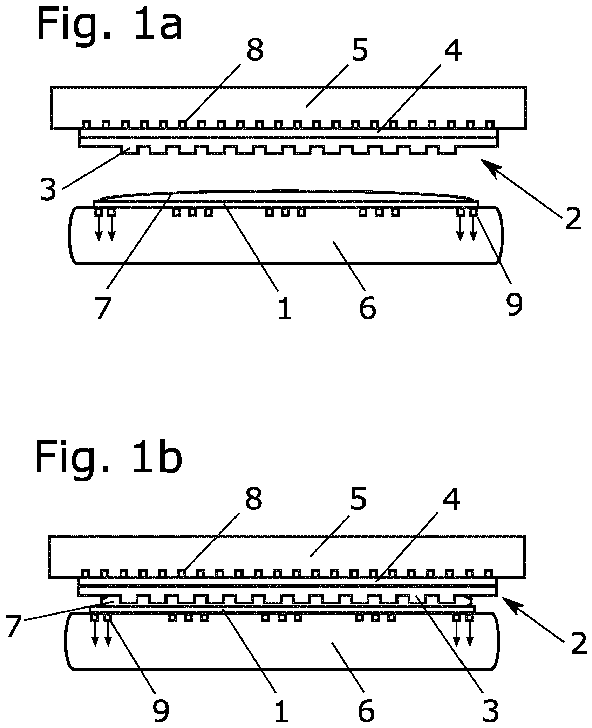

Figur 1a zeigt eine Querschnittsansicht der Vorrichtung in einer ersten Ausführungsform. Figur 1a zeigt insbesondere die Aufnahmeeinrichtungen 5 und 6 einer Vorrichtung zur Aufnahme des Strukturstempels 2 und des Substrats 1. Die Aufnahmeflächen der Aufnahmeeinrichtungen 5 und 6 sind insbesondere an die Abmessungen und Umfangskontur des Strukturstempels 2 und des Substrats 1 angepasst.

Der Strukturstempel 2 aus Figuren 1a bis 1e ist in einer bevorzugten Ausführungsform ein elastomerer Weichstempel 2. Der elastomere Strukturstempel 2 ermöglicht einen konformen, gleichmäßigen Kontakt über große Oberflächen. Um eine gute Trennung von Strukturstempel 2 und Substrat 1 zu gewährleisten, hat die Stempeloberfläche eine möglichst niedrige Oberflächenenergie.

Bei Bedarf wird der elastomere Strukturstempel 2 durch einen Träger beziehungsweise Stempelträgersubstrat 4 unterstützt. In einer anderen Ausführungsform werden Glasträgersubstrate mit verschiedenen Dicken verwendet. Durch die Verwendung eines Stempelträgersubstrats 4 verliert der elastomere Strukturstempel 2, zumindest teilweise, seine Flexibilität. Andererseits kann die Flexibilität des Strukturstempels 2 durch die Auswahl des Trägers 4 gesteuert werden. Der Träger 4 kann in einer alternativen Ausführungsform eine Platte sein. In einer dritten Ausführungsform wird kein Träger 4 benötigt. Der Aufbau des Strukturstempels 2 ist nicht auf die Ausführungsform aus den Figuren 1a bis 1e eingeschränkt.

Die Strukturen 3, 3' des Strukturstempels 2 haben Abmessungen im Mikrometer und/oder im Nanometer Bereich. Die Fixierung des Strukturstempels 2 erfolgt in einer bevorzugten Ausführungsform durch Vakuum beziehungsweise Unterdruck über die Vakuumbahnen 8 einer Vakuumeinrichtung (nicht dargestellt). Im Ausführungsbeispiel gemäß Figuren 1a bis 1e wird der Unterdruck zur Fixierung des Strukturstempels an mehreren zueinander konzentrisch verlaufenden, die Aufnahmefläche der Stempelaufnahmeeinrichtung 5 zur Aufnahme des Strukturstempels bedeckenden, Vakuumbahnen 8 angelegt. In einer alternativen Ausführungsform befinden sich die Vakuumbahnen 8 nur im Bereich eines Seitenrandes der Aufnahmefläche der Stempelaufnahmeeinrichtung 5. In dieser alternativen Ausführungsform ist nur ein äußerer Ringabschnitt der Aufnahmefläche der Stempelaufnahmeeinrichtung 5 zur Fixierung des Strukturstempels 2 mittels Vakuumbahnen 8 vorgesehen.

In einer bevorzugten Ausführungsform gemäß Figuren 1a bis 1e ist das Substrat 1 sehr dünn im Vergleich zu Substraten im Stand der Technik, so dass eine Flexibilität gegeben ist. In einer ersten Ausführungsform wird kein Trägersubstrat zur Stabilisierung des Substrats 1 beziehungsweise Produktsubstrats verwendet. Das dünne Substrat 1 ist an einer Aufnahmeeinrichtung 6 fixiert, so dass die Handhabung erleichtert wird. In einer alternativen Ausführungsform wird ein Träger (nicht dargestellt) zur Stabilisierung vom dünnen Substrat 1 verwendet. Der Träger kann beispielsweise ein Trägersubstrat, eine Trägerplatte oder eine Trägerfolie sein. Der Träger stützt das Substrat und verhindert ein durchbiegen, ist aber auch selbst dünn und besitzt somit auch eine ausreichende Flexibilität. Dadurch ist das zu prägende Substrat flexibel.

Das Substrat aus Figuren 1a bis 1e ist in einer bevorzugten Ausführungsform ein sehr dünnes Substrat. Die Dicke des Substrats 1 liegt insbesondere zwischen 1 µm und 2000 µm, mit Vorzug zwischen 10 µm und 750 µm, mit größerem Vorzug zwischen 100 µm und 500 µm.

Die Dicke von Strukturstempel 2, Substrat 1 und der Prägemasse 7 ist in den Figuren nicht maßstabsgetreu dargestellt, um die Darstellung zu verbessern.

Die Aufnahmefläche der Substrataufnahmeeinrichtung 6 aus Figur 1a ist bevorzugt an die Abmessungen des Substrats 1 zumindest weitgehend angepasst. Die Fixierung des Substrats 1 erfolgt in einer bevorzugten Ausführungsform durch Vakuum beziehungsweise Unterdruck über die Vakuumbahnen 9 einer Vakuumeinrichtung (nicht dargestellt).

Im Ausführungsbeispiel gemäß Figuren 1a bis 1e wird der Unterdruck zur Fixierung des Substrats 1 an mehreren zueinander konzentrisch verlaufenden, die Aufnahmefläche der Substrataufnahmeeinrichtung 6 zur Aufnahme des Substrats 1 bedeckenden, Vakuumbahnen 9 angelegt. Die Fixiermittel sind auch als, insbesondere gleichmäßig an den Aufnahmeflächen verteilt und in Zonen gegliederte, insbesondere separat steuerbare, Fixierelemente ausgebildet. In den Figuren 1a und 1b werden zuerst nur die Vakuumbahnen 9 in der Zone eines Seitenrandes der Aufnahmefläche der Substrataufnahmeeinrichtung 6 separat gesteuert und aktiviert (Steuerung beziehungsweise Aktivierung durch Pfeile dargestellt). Der Randbereich erstreckt sich insbesondere bis zum halben Radius, vorzugsweise bis zu einem Viertel des Radius, der Aufnahmefläche.

Das Substrat gemäß Figur 1a wurde bereits vollflächig mit einer Prägemasse 7 beschichtet. In einer bevorzugten Ausführungsform wird das Verfahren in Kombination mit den etablierten industriellen Belackungsverfahren angewendet werden wie zum Beispiel Spin-Coating Verfahren. Die Aufbringung der Schichten erfolgt insbesondere mit Spin-, Sprüh- oder Inkjet-Verfahren sowie Tauchbeschichtungs- oder Walzenbeschichtungsverfahren. Die Belackung kann vom Prägeprozess getrennt in einem eigenen Modul durchgeführt werden.

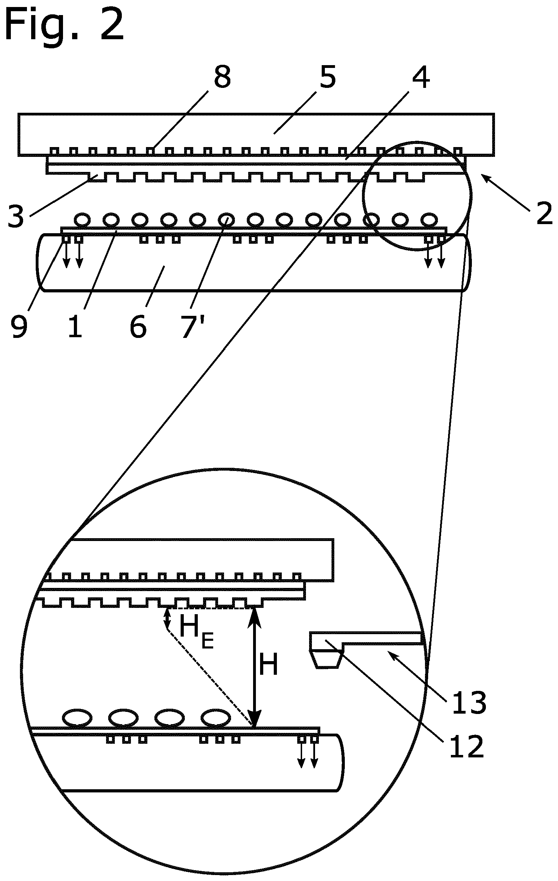

Die Auftragung der Prägemasse 7' kann in einer alternativen Ausführungsform gemäß Figur 2 mit einer Dosiereinrichtung 13 mit einer Düse 12, die zwischen dem Strukturstempel 2 und das Substrat 1 anordbar ist, durchgeführt werden. In dieser Ausführungsform wird die Prägemasse 7' als Tropfen in definierten Abständen auf das Substrat 1 aufgetragen. Das Volumen der Tropfen wird genau bemessen und gesteuert, so dass eine Zwischenschichtdicke einer möglichen Zwischenschicht, die zwischen Strukturvertiefung der geprägten Struktur und Substratoberfläche verbleibt, eingestellt wird. Bevorzugt wird eine möglichst geringe Zwischenschichtdicke. Bevorzugt liegt die Zwischenschichtdicke zwischen 50 µm und 0,01 nm, noch bevorzugter zwischen 10 µm und 0,01 nm, am bevorzugtesten zwischen 1 µm und 0,01 nm.

In einer Ausführungsform ermöglicht die Substrataufnahmeeinrichtung 6 außerdem das Handling von Substraten 1 mit flüssiger Schicht drauf. Die flüssige Schicht ist insbesondere ein flüssiger Prägelack beziehungsweise Prägemasse 7, 7' der sich im Interface während des Kontaktierens befindet. Figur 1b zeigt die Vorrichtung bei einem weiteren Prozessschritt. Nach einer Ausrichtung werden die Kontaktflächen von Substrat 1 und Strukturstempel 2 angenähert und vollflächig kontaktiert.

In der Ausführungsform erfolgt eine annähernde Relativbewegung zwischen dem Strukturstempel 2 und dem Substrat 1, 1'. Bevorzugt wird nur eine der Aufnahmeeinrichtungen 5, 6 bewegt. Bevorzugt wird nur der Strukturstempel 2 relativ zur statischen Substrataufnahmeeinrichtung 6 angenähert.

Beim Schritt der Kontaktierung von Strukturstempel 2 und Substrat 1 gemäß Figur 1b werden nur die Fixiermittel im Randbereich der Substrataufnahmeeinrichtung 6 eingesetzt. Sobald der Strukturstempel 2 in Kontakt mit dem Substrat 1 ist, wird die Fixierung vom mit Prägemasse 7, 7' beschichteten Substrat 1 durch Unterbrechung des Vakuums gelöst. Durch Reduzierung des Unterdrucks an der Aufnahmefläche kann das Ablösen vom Substrat 1 kontrolliert durchgeführt werden. Entsprechend werden die Fixierelemente gesteuert. Der Strukturstempel 2 bleibt unverändert an der Stempelaufnahmeeinrichtung 5 fixiert.

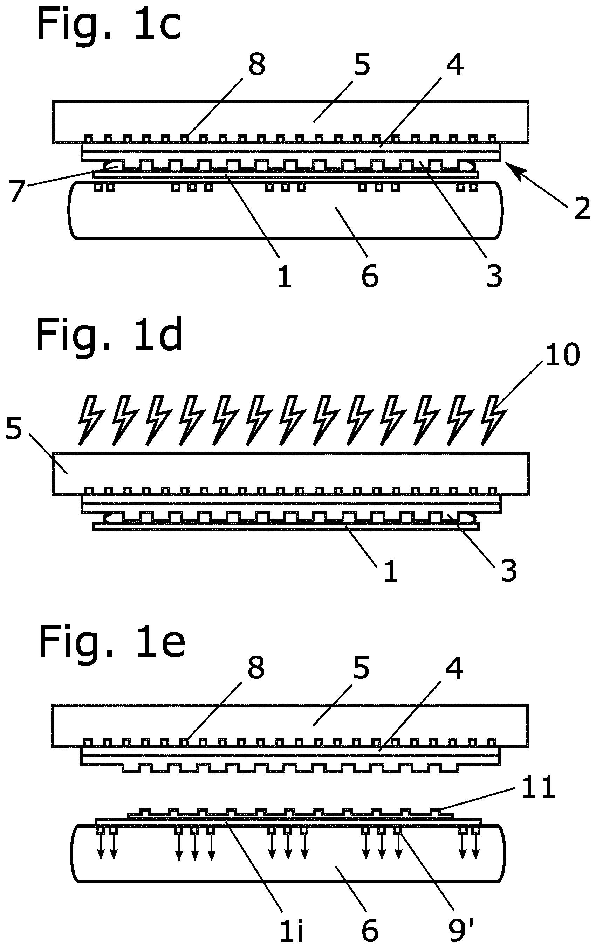

Nach Loslösen bleibt das Substrat 1 gemäß Figur 1c bedingt durch die zwischen Substrat 1 und Strukturstempel 2 durch die vorhandene Prägemasse 7, 7' wirkende Kapillareffekte beziehungsweise Kapillarkraft am Strukturstempel 2 haften und der Prägeprozess wird vollflächig initiiert. Eine zusätzliche externe Anpresskraft ist erfindungsgemäß nicht notwendig für eine erfolgreiche Prägung beziehungsweise Erzeugung. Die Aufnahmeeinrichtungen 5, 6 werden nur soweit angenähert so dass sich der Abstand H (siehe Figur 2) auf einem genau definierten Endabstand H_{E} reduziert, so dass der Imprintprozess gestartet wird ohne eine zusätzliche externe Anpresskraft anzuwenden. Der Endabstand H_{E} ist insbesondere kleiner als 100 µm, mit Vorzug kleiner als 10 µm, mit größtem Vorzug kleiner als 500 nm, mit allergrößtem Vorzug kleiner als 100 nm. Durch die Wirkung von Kapillarkräften wird das dünne, flexible Substrat 1 konform an den Strukturstempel 2 herangezogen. Durch die Flexibilität des Substrats 1 und den gewonnenen Freiheitsgrad durch das Loslösen des Substrats 1 kann sich das Substrat 1 verformen und an den Strukturstempel 2 anpassen. Dadurch wird eine gleichmäßige Kontaktierung während der Prägung ermöglicht.

Figur 1c zeigt die Vorrichtung mit auf die Stempelaufnahmeeinrichtung 5 geladenem, insbesondere UV-transparenten, Strukturstempel 2, wobei das Substrat 1 am Strukturstempel 2 mit der dazwischenliegenden Prägemasse 7 durch Kapillarkräfte zusammengehalten wird. Dafür muss mindestens das Substrat 1 eine hohe Flexibilität aufweisen. Auf Grund der Viskosität der Prägemasse 7 werden auch durch Kapillarwirkung die Zwischenräume des Strukturstempels 2 vollständig damit ausgefüllt.

In der Ausführungsform gemäß Figur 1c liegt das Substrat 1, nach Unterbrechung der Fixierung an der Substrataufnahmeeinrichtung 6 und nach Wirkung der Kapillarkräfte, nicht mehr auf der Aufnahmefläche der Substrataufnahmeeinrichtung 6 auf. In einer zweiten Ausführungsform (nicht dargestellt) liegt das Substrat 1 noch auf der Aufnahmefläche der Substrataufnahmeeinrichtung 6 auf, ohne (aktive) Fixierung durch Fixiermittel und ohne Einwirkung externer Kräfte. Ob ein Kontakt zwischen Substrat 1 und Aufnahmefläche der Substrataufnahmeeinrichtung 6 nach Loslösen der Substrat-Fixierung durch Fixiermittel 9 noch vorhanden ist, hängt von mehreren Prozessparametern ab wie beispielsweise die Menge und Viskosität der Prägemasse 7, 7', die Größe der Strukturen 3, 3' des Strukturstempels 2, die Einstellung des Endabstandes H_{E}, usw.

In einer alternativen Ausführungsform (nicht dargestellt) befindet sich der Strukturstempel 2 auf der unteren Aufnahmeeinrichtung und das Substrat 1 auf der oberen Aufnahmeeinrichtung. Nach Loslösen bleibt das Substrat 1, bedingt durch die zwischen Substrat 1 und Strukturstempel 2 durch die vorhandene Prägemasse wirkende Kapillarkraft, am Strukturstempel 2 haften und liegt, auch bedingt durch die zusätzliche Schwerkraft, auf dem mit beispielsweise als Tropfen in definierten Abständen auf dem Strukturstempel 2 aufgetragen Prägemasse 7, auf.

In sämtlichen dargestellten Ausführungsformen ist kein externer Druck, insbesondere kein Anpressen notwendig, um einen konformen beziehungsweise lückenlosen Kontakt zwischen Strukturstempel 2 und Substrat 1 mit Prägemasse 7 zu erzielen. Die Vorrichtungen haben den Vorteil, dass keine Aktuatoreinrichtung eingesetzt werden muss, um Stempel 2 und/oder Substrat 1 mit einer der Übertragung der Stempelstruktur 3 dienenden und orthogonal zur Substrataufnahmefläche resultierenden Kraft zu beaufschlagen.

Das Verfahren verhindert eine durch Anpressen verursachte Verformung der Strukturen 3 des Strukturstempels 2. Und die Flexibilität des Substrats 1 ermöglicht Unregelmäßigkeiten des Strukturstempels 2 und/oder des Substrats 1 auszugleichen und auch weitere Prägedefekte, beispielsweise solche die durch Lufteinschlüsse verursacht werden, zu verhindern, wodurch die Qualität des Prägeprozesses sehr hoch ist.

Im nächsten Prozessschritt gemäß Figur 1d findet eine direkte Vernetzung der aushärtbaren Prägemasse 7, insbesondere Photoresist oder Lack, mittels UV-Licht 10 statt. Allgemeiner kann die Aushärtung durch elektromagnetische Strahlung, durch Wärme, durch Strom, durch magnetische Felder oder andere Verfahren durchgeführt werden. Bevorzugt erfolgt die Aushärtung durch die transparente Stempelaufnahmeeinrichtung 5 und den transparenten Strukturstempel 2 hindurch. Denkbar ist auch eine Aushärtung der Prägemasse 7 über eine Strahlungsquelle in oder an der Stempelaufnahmeeinrichtung 5.

Im letzten Prozessschritt gemäß Figur 1e findet die Entformung von Substrat 1 und Strukturstempel 2 statt. Das Substrat 1 wird vor der Entformung wieder an die Substrataufnahmeeinrichtung 6 fixiert. Die Fixierung des Substrats 1 erfolgt durch Vakuum beziehungsweise Unterdruck über die Vakuumbahnen 9' einer Vakuumeinrichtung (nicht dargestellt).

Für die Entformung werden alle Fixierelemente der Substrataufnahmeeinrichtung 6, insbesondere separat steuerbare und gleichmäßig an den Aufnahmeflächen verteilte Fixierelemente 9' eingesetzt und aktiviert (Aktivierung durch Pfeile dargestellt).

Figur 1e zeigt die geprägte und ausgehärtete Prägemasse 11 am Substrat 1 nach der Prägung 1i. Das Verfahren ermöglicht eine hochauflösende Strukturierung im sub-µm Bereich, mit Vorzug unter 20 µm, mit größerem Vorzug unter 2 µm, noch bevorzugter unter 200 nm, mit allergrößtem Vorzug unter 10 nm.

Bevorzugt verfügt die Vorrichtung über eine Modulgruppe mit einem gemeinsamen, und bei Bedarf gegenüber der Umgebungsatmosphäre abschließbaren Arbeitsraum. Dabei können die Module, zum Beispiel Belackungs-Modul, Imprint-Modul und Entlade-Modul, clusterförmig oder sternförmig um ein Zentralmodul mit einer Bewegungseinrichtung (Robotersystem) angeordnet werden.

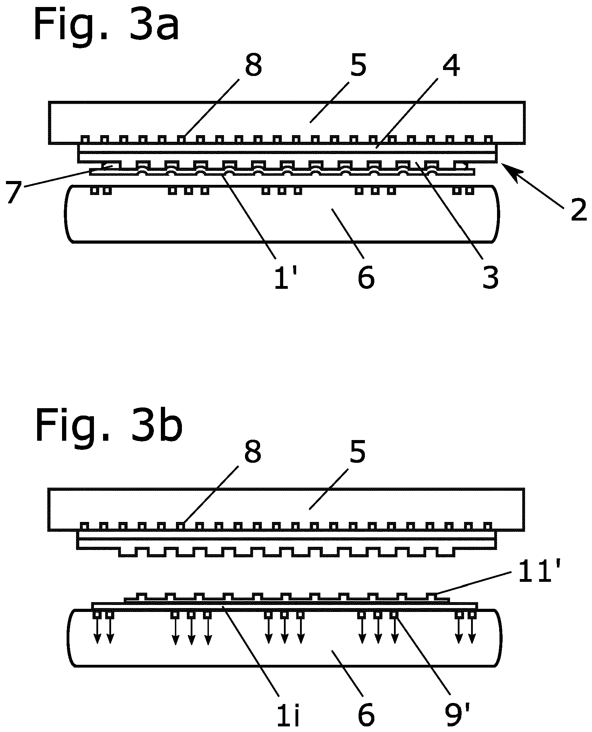

Figur 3a zeigt eine Ausführungsform mit einer ausgeprägten Substratverformung durch Wirkung von Kapillarkräften nach der Kontaktierung von Substrat 1' und Strukturstempel 2 mit der dazwischenliegenden Prägemasse 7. Die Verhältnisse der einzelnen Bauteile und des Substrats 1' aus Figur 3a sind teilweise unverhältnismäßig, was insbesondere auf die stark vergrößert dargestellten Strukturen 3 des Strukturstempels 2 zurückzuführen ist. Durch die Wirkung von Kapillarkräften wird das dünne, flexible Substrat 1' konform an den Strukturstempel 2 herangezogen. Durch die Flexibilität des Substrats 1' und den gewonnenen Freiheitsgrad durch das Loslösen des Substrats 1' von der Substrataufnahmeeinrichtung 6 kann sich das Substrat 1' verformen und an den Strukturstempel 2 anpassen. Dadurch wird eine gleichmäßige Kontaktierung während der Prägung ermöglicht. Dafür muss mindestens das Substrat 1, 1', bevorzugt Substrat 1, 1' und Strukturstempel 2, eine hohe Flexibilität aufweisen. Durch die hohe Flexibilität des Substrats 1, 1' und die konforme Kontaktierung werden Prägedefekte reduziert oder bevorzugt eliminiert.

Prägedefekte, die im Stand-der-Technik der Nanoimprintlithographie auftreten können sind unter anderem Risse, ungleichmäßig gefüllte Stempelstrukturen (daher Lufteinschlüsse), und ungleichmäßige Lack-Schichtdicke. Dabei ist die Adhäsion zwischen Prägemasse, beispielsweise ein Lack, und Strukturstempel kritisch, da Verzerrungen oder Risse auftreten können, wenn beispielsweise die ausgehärtete Prägemasse 11' stärker in einer Vertiefung des Strukturstempels 2 haftet, so dass eine geprägte Struktur beim Entformen reißen kann. Ungleichmäßig gefüllte Stempelstrukturen 3 führen zum Fehlen von einzelnen geprägten Strukturen in der ausgehärteten Prägemasse 11'. Das Füllen der Stempelstrukturen ist abhängig von Faktoren wie u.a. die Viskosität der Prägemasse 7, die Dicke der Beschichtung beziehungsweise die Größe und die Anordnung der aufgetragenen Prägemasse-Tropfen sowie die Zeit.

Weitere Prägedefekte stammen insbesondere von Defekten des Strukturstempels 2 selber, wie beispielsweise eine stellenweise geringere Tiefe der Strukturen 3 oder eine unebene Oberfläche. Defekte wie beispielsweise eine unebene Oberfläche des Strukturstempels 2 werden durch die Flexibilität des Substrats 1 kompensiert.

Weiche Strukturstempel 2 können sich während des Prozesses nicht verformen, da kein externer Druck angelegt wird. Auch das Substrat 1, 1' ist so dünn, dass Stempeldefekte oder im Stand-der-Technik sonst auftretende Defekte kompensiert werden können oder gar nicht entstehen. Figur 3b zeigt nach der Entformung die geprägte und ausgehärtete Prägemasse 11' am Substrat 1i.

Die vorgeschlagene Erfindung kann insbesondere für die Herstellung folgender Produkte eingesetzt werden:
- 1D-, 2D-, und/oder 3D-diffraktive optische Elemente (DOE),
- mikrofluidische Baugruppen,
- Linsen und Linsensysteme,
- Fresnel-Linsen,
- Biomedizinische Elemente,
- Polarisatoren,
- nanostrukturierte Elektroden,
- IR-Wellenleiter,
- Winkeloptik für virtuelle Realität Anwendungen,
- Glasfaseranschlüsse,
- Arbeitsstempel für Imprintlithographie
- Und Weitere.

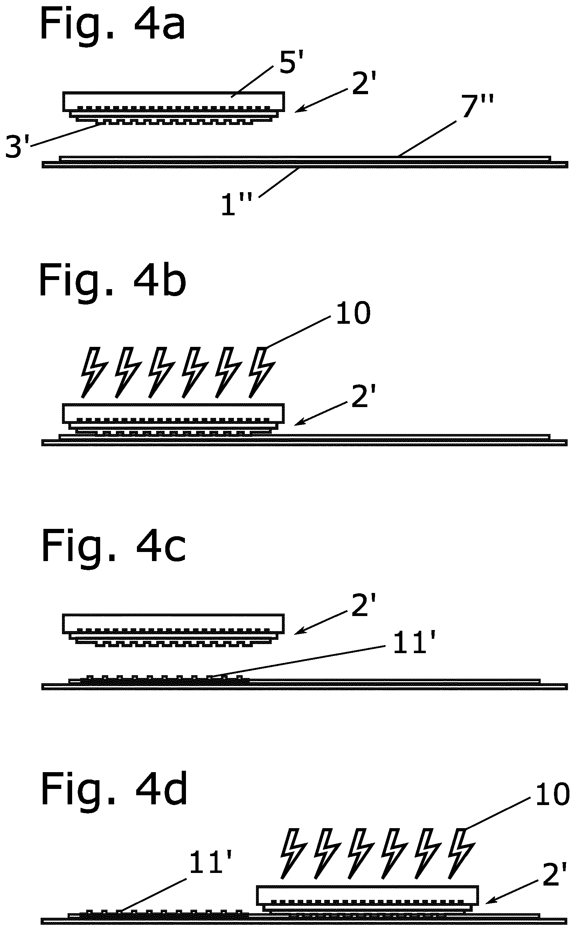

Die Figuren 4a bis 4d zeigen eine andere Ausführungsform in einem Step-and-repeat Verfahren. Dabei wird ein Strukturstempel 2' verwendet, der kleiner ist als das Substrat 1", auf dem die Strukturen geprägt werden sollen. Der Vorgang wird gemäß Figuren 4a bis 4d entsprechend oft beziehungsweise beliebig wiederholt, um das gesamte Substrat 1" mit Prägemasse 7" zu prägen. Die Anlage kann bevorzugt in einer Prozesskammer installiert sein, die zur Umgebung hermetisch abgeschlossen werden kann. Damit werden eine Evakuierung der Prozesskammer und/oder eine Ventilierung der Prozesskammer mit einem beliebigen Gas beziehungsweise Gasgemisch ermöglicht.

Figur 4a zeigt das Substrat 1" mit einer vollflächigen Schicht an Prägemasse 7". In einer anderen Ausführungsform können Tropfen der Prägemasse auf dem Substrat 1"in definierten Abständen aufgetragen werden. Der Step-and-repeat Strukturstempel 2' ist dabei kleiner als das Substrat 1". Figur 4a zeigt insbesondere auch eine Querschnittsansicht der Aufnahmeeinrichtung 5' einer Vorrichtung zur Aufnahme des Strukturstempels 2'. Die Strukturen 3' des Strukturstempels 2' haben Abmessungen im Mikrometer und/oder im Nanometer Bereich. Die Fixierung des Strukturstempels 2' an der Stempelaufnahmeeinrichtung 5' erfolgt in einer bevorzugten Ausführungsform durch Vakuum beziehungsweise Unterdruck über die Vakuumbahnen einer Vakuumeinrichtung (nicht dargestellt).

In einer vorteilhaften Ausführungsform ist vorgesehen, dass die Vorrichtung Aushärtemittel zum, insbesondere abschnittsweisen, vorzugsweise mit dem step-and-repeat-Verfahren entsprechenden, insbesondere einer Stempelfläche des Strukturstempels korrespondierenden, Abschnitten, Aushärten des geprägten Substrats 1" aufweist.

Die Step-and-repeat Vorrichtung ist als eine Weiterentwicklung der Vorrichtung, die in der Patentschrift EP2287666A1 beschrieben wird, zu sehen. In EP2287666A1 wird eine Step-and-repeat Vorrichtung zur Prägung eines Substrats in mehreren Prägeschritten innerhalb des Prägevorgangs und die in der Vorrichtung enthaltenen weitere Einrichtungen, insbesondere eine Justiereinrichtung, beschrieben.

Im Prozessschritt gemäß Figur 4b wird die Prägemasse 7" durch den Step-and-repeat Strukturstempel 2' strukturiert. Der Strukturstempel 2' wird dabei an eine erste Position verfahren um in dieser ersten Position zu Prägen. Bevorzugt wird nur der Strukturstempel 2' relativ zum statischen Trägersubstrat angenähert. Nach der Kontaktierung findet eine direkte Vernetzung der aushärtbaren Prägemasse 7", insbesondere Photoresist oder Lack, mittels UV-Licht 10 statt. Allgemeiner kann die Aushärtung durch elektromagnetische Strahlung, durch Wärme, durch Strom, durch magnetische Felder oder andere Verfahren durchgeführt werden. Bevorzugt erfolgt die Aushärtung durch die transparente Stempelaufnahmeeinrichtung 5' und den transparenten Strukturstempel 2' hindurch. Erfindungsgemäß denkbar ist auch eine Aushärtung der Prägemasse 7" über eine Strahlungsquelle in oder an der Stempelaufnahmeeinrichtung 5'.

Nach der Entformung gemäß Figur 4c ist ein definierter Abschnitt des Substrats 1" geprägt mit einer ausgehärteten Prägemasse 11'.

In einem weiteren Prozessschritt des Step-and-repeat Verfahrens gemäß Figur 4d verfährt der Step-and-repeat Strukturstempel 2' von der ersten Position zu einer zweiten vorgegebenen, und von der ersten Position unterschiedlichen, Position und prägt erneut. Nach der Kontaktierung findet wieder eine direkte Vernetzung der geprägten aushärtbaren Prägemasse 7", mittels UV-Licht 10 statt. Erfindungsgemäß ist auch eine Mehrfach-Aushärtung denkbar, wobei nach jedem einzelnen Prägeschritt lokal eine erste Aushärtung stattfindet und nach Abschluss des Step-and-repeat Verfahrens eine weitere Aushärtung des gesamten Substrats 1" stattfindet, beispielsweise in einem eigenen Modul.

Der Prozess gemäß Figuren 4a bis 4d kann so oft fortgesetzt werden, bis die gewünschte Fläche des Substrats 1" geprägt wurde. Der Strukturstempel 2' in dieser Ausführungsform ermöglicht nach Kontaktierung mit der Prägemasse 7" am Substrat 1" eine Prägung ohne externe Krafteinwirkung. Der Strukturstempel besitzt Mittel zur Bewegung, insbesondere parallel zur Substratoberfläche und ein Hebesystem zur Annäherung entlang der Z-Richtung sowie zur Entformung (nicht dargestellt). Die hohe Präzision der Verfahrtische der Step-and-Repeat Vorrichtung ermöglicht eine nahtlose Prägung mit dem Strukturstempel 2' am gesamten Umfang des Substrats 1". Eine Ausrichtung an zuvor geprägten Strukturen, insbesondere beispielsweise einer Überlappungsstruktur am Rand eines vorhergeprägten Strukturabschnitts ist erfindungsgemäß möglich. Denkbar ist auch die Verwendung eines Endlossubstrates im Step-and-repeat Verfahren. Dabei ist das Endlossubstrat insbesondere ein auf einer ersten Rolle gespeichertes Substrat, dessen Länge um ein Vielfaches größer ist als seine Breite. Insbesondere ist das Endlossubstrat eine Folie.

Durch eine wiederholte und nebeneinander ausgeführte Prägung mit dem Strukturstempel 2' werden beispielsweise Linsenarrays, insbesondere Mikro- und/oder Nanolinsenarrays, hergestellt.

Eine zusätzliche externe Anpresskraft ist erfindungsgemäß nicht notwendig für eine erfolgreiche Prägung. Die Stempelaufnahmeeinrichtungen 5' wird in der vorgegebenen Position nur soweit an das Substrat 1" angenähert so dass sich der Abstand H auf einem genau definierten Endabstand H'_{E} reduziert, so dass der Imprintprozess gestartet wird ohne eine zusätzliche externe Anpresskraft anzuwenden. Der Endabstand H'_{E} ist insbesondere kleiner als 100 µm, mit Vorzug kleiner als 10 µm, mit größtem Vorzug kleiner als 500 nm, mit allergrößtem Vorzug kleiner als 100 nm. Durch die Wirkung von Kapillarkräften wird das dünne, flexible Substrat 1" konform an den Strukturstempel 2' herangezogen. Durch die Flexibilität des Substrats 1" kann sich das Substrat 1" verformen und an den Strukturstempel 2' anpassen. Dadurch wird eine gleichmäßige Kontaktierung während der Prägung ermöglicht.

### Bezugszeichenliste

- 1, 1', 1": Substrat, Produktsubstrat
- 1i: Substrat nach Prägung
- 2, 2': Strukturstempel
- 3, 3': Prägestruktur
- 4: Stempelträgersubstrat oder Rückplatte zur Stabilisierung
- 5, 5': Stempelaufnahmeeinrichtung
- 6: Substrataufnahmeeinrichtung
- 7, 7', 7": Prägemasse
- 8, 8': Vakuumbahnen in der Stempelaufnahmeeinrichtung
- 9, 9': Vakuumbahnen in der Substrataufnahmeeinrichtung
- 10: Strahlungsquelle
- 11, 11': Geprägte und ausgehärtete Prägemasse
- 12: Düse
- 13: Dosiereinrichtung
- H: Abstand
- H_{E}, H'_{E}: Endabstand

## Patentansprüche

1. Verfahren zum Erzeugen von Mikro- und/oder Nanostrukturen, mit mindestens den folgenden Schritten mit dem folgenden Ablauf:
a) Fixierung eines Substrats (1, 1',1") mit einer Prägemasse (7, 7', 7") auf einer Substrataufnahmeeinrichtung (6),
b) Kontaktierung eines Strukturstempels (2, 2') mit der Prägemasse (7, 7', 7"),
c) Zumindest teilweise Aufhebung der Fixierung des Substrates (1, 1',1"),
d) Aushärtung der Prägemasse (7, 7', 7"),
f) Entformung der Prägemasse (7, 7', 7") von dem Strukturstempel (2, 2'),
wobei der Strukturstempel (2, 2') ein hartes UV-transparentes Material aufweist, wobei das Substrat (1, 1',1") flexibel ist und sich dadurch zumindest teilweise konform an den Strukturstempel (2, 2') nach der zumindest teilweisen Aufhebung der Fixierung anpasst,
wobei eine Dicke des Substrats (1, 1',1") zwischen 1 µm und 2000 µm, mit Vorzug zwischen 10 µm und 750 µm, mit größerem Vorzug zwischen 100 µm und 500 µm liegt.

2. Verfahren nach Anspruch 1, wobei nach der zumindest teilweisen Aufhebung der Fixierung des Substrates eine zumindest teilweise Ablösung des Substrates (1, 1',1") von der Substrataufnahmeeinrichtung (6), insbesondere durch eine Relativbewegung von Substrataufnahmeeinrichtung (6) und dem Substrat (1, 1',1") und/oder durch eine Relativbewegung von Substrataufnahmeeinrichtung (6) und einer Stempelaufnahmeeinrichtung (5, 5') und/oder durch Kapillarkräfte, erfolgt.

3. Verfahren nach wenigstens einem der vorhergehenden Ansprüche, wobei die Prägemasse (7, 7', 7") ohne Druck und/oder ohne Anpressen, insbesondere durch Kapillarkräfte, strukturiert wird.

4. Verfahren nach wenigstens einem der vorhergehenden Ansprüche, wobei das Substrat (1, 1',1") mit der Prägemasse (7, 7', 7") durch mindestens ein steuerbares und in der Substrataufnahmeeinrichtung (6) angeordnetes Fixierelement (9, 9'), insbesondere durch Vakua und/oder Unterdruck, auf der Substrataufnahmeeinrichtung (6) fixiert wird und/oder durch das mindestens eine steuerbare Fixierelement (9, 9'), insbesondere durch Abschalten des Unterdrucks und/oder durch Erzeugen eines Überdrucks, die Fixierung aufgehoben wird.

5. Verfahren nach wenigstens einem der vorhergehenden Ansprüche, wobei die Fixierung des Substrates (1, 1',1") und die zumindest teilweise Aufhebung der Fixierung des Substrates (1, 1',1") gesteuert wird, insbesondere durch ein Steuern des mindestens einen steuerbaren Fixierelementes (9, 9'), so dass die Strukturierung der Prägemasse (7, 7', 7") und/oder die Freigabe beziehungsweise die Ablösung des Substrates (1, 1',1") nach der Kontaktierung des Strukturstempel (2, 2') mit der Prägemasse (7, 7', 7") zu einem bestimmten Zeitpunkt erfolgt.

6. Verfahren nach wenigstens einem der vorhergehenden Ansprüche, wobei der Strukturstempel (2, 2') so ausgebildet ist, dass nach der zumindest teilweisen Aufhebung der Fixierung die Prägemasse (7, 7', 7") und/oder das Substrat (1, 1',1") konform an den Strukturstempel (2, 2') ohne externen Druck, insbesondere durch Kapillarkräfte, angepasst werden.

7. Verfahren nach wenigstens einem der vorhergehenden Ansprüche, wobei das Substrat (1, 1',1") von der Prägemasse (7, 7', 7"), insbesondere durch Kapillarkräfte, nach der Kontaktierung und/oder nach der zumindest teilweisen Aufhebung der Fixierung, gehalten wird.

8. Verfahren nach wenigstens einem der vorhergehenden Ansprüche, wobei die Mikro- und/oder Nanostrukturen in mehreren Schichten übereinander und/oder in einem Step-and-Repeat-Verfahren nebeneinander hergestellt werden.

9. Verfahren nach wenigstens einem der vorhergehenden Ansprüche, wobei eine Viskosität der Prägemasse (7, 7', 7") kleiner als 100000 cp (100 Pa s), mit Vorzug kleiner als 10000 cP (10 Pa s), mit größerem Vorzug kleiner als 1000 cP (1 Pa s), mit größtem Vorzug kleiner als 500 cP (0,5 Pa s) beträgt.

10. Verfahren nach wenigstens einem der vorhergehenden Ansprüche, wobei der Strukturstempel (2, 2') eine Prägestruktur (3, 3') aufweist und/oder mit einer Prägestruktur (3, 3') beschichtet ist.

11. Verfahren nach wenigstens einem der vorhergehenden Ansprüche, wobei der Strukturstempel (2, 2') aus Glas, Quarz, oder Siliziumdioxid ist.

## Claims

1. A method for creating micro- and/or nanostructures, with at least the following steps with the following sequence:
a) fixing a substrate (l, l', 1") with an embossing compound (7, 7', 7") on a substrate mounting device (6),
b) contacting a structural stamp (2, 2') with the embossing compound (7, 7', 7"),
c) at least partial removal of the fixing of the substrate (l, 1', 1"),
d) curing of the embossing compound (7, 7', 7"),
f) demoulding of the embossing compound (7, 7', 7") from the structural stamp (2, 2'),
wherein the structural stamp (2, 2') has a hard UV-transparent material, wherein the substrate (l, l', l") is flexible and thus adapts to at least partially conform to the structural stamp (2, 2') after the at least partially removal of the fixing,
wherein a thickness of the substrate (l, l', l") lies between 1 µm and 2000 µm, preferably between 10 µm and 750 µm, more preferably between 100 µm and 500 µm.

2. The method according to claim 1, wherein after the at least partial removal of the fixing of the substrate, an at least partial detachment of the substrate (1, 1', 1") from the substrate mounting device (6) takes place, in particular by a relative movement of the substrate mounting device (6) and the substrate (1, 1', 1") and/or by a relative movement of substrate mounting device (6) and a stamp mounting device (5, 5') and/or by capillary forces.

3. The method according to at least one of the preceding claims, wherein the embossing compound (7, 7', 7") is structured without pressure and/or without pressing, in particular by capillary forces.

4. The method according to at least one of the preceding claims, wherein the substrate (1, 1', 1") with the embossing compound (7, 7', 7") is fixed on the substrate mounting device (6) by at least one controllable fixing element (9, 9') arranged in the substrate mounting device (6), in particular by vacuum and/or underpressure, and/or the fixing is removed by at least one controllable fixing element (9, 9'), in particular by switching off the underpressure and/or by generating an overpressure.

5. The method according to at least one of the preceding claims, wherein the fixing of the substrate (1, 1', 1") and the at least partial removal of the fixing of the substrate (1, 1', 1") is controlled, in particular by controlling the at least one controllable fixing element (9, 9'), so that the structuring of the embossing compound (7, 7', 7") and/or the release or detachment of the
substrate (l, l', 1) takes place at a certain point in time after contacting of the structural stamp (2, 2') with the embossing compound (7, 7', 7").

6. The method according to at least one of the preceding claims, wherein the structural stamp (2, 2') is designed in such a way that after the at least partial removal of the fixing, the embossing compound (7, 7', 7") and/or the substrate (l, l', l") are adapted to conform to the structural stamp (2, 2') without external pressure, in particular by capillary forces.

7. The method according to at least one of the preceding claims, wherein the substrate (l, 1', 1") is held by the embossing compound (7, 7', 7"), in particular by capillary forces, after contacting and/or after at the at least partial removal of the fixing.

8. The method according to at least one of the preceding claims, wherein the micro- and/or nanostructures are produced in several layers on top of each other and/or in a step-and-repeat process side by side.

9. The method according to at least one of the preceding claims, wherein a viscosity of the embossing compound (7, 7', 7") is less than 100000 cP (100 Pa·s), preferably less than 10000 cP (10 Pa·s), more preferably less than 1000 cP (l Pa·s), most preferably less than 500 cP (0.5 Pa·s).

10. The method according to at least one of the preceding claims, wherein the structural stamp (2, 2') has an embossed structure (3, 3') and/or is coated with an embossed structure (3, 3').

11. The method according to at least one of the preceding claims, wherein the structural stamp (2, 2') is made of glass, quartz, or silicon dioxide.

## Revendications

1. Procédé pour la production de microstructures et/ou nanostructures, comprenant au moins les étapes suivantes avec le déroulement suivant :
a) fixation d'un substrat (1, 1', 1") avec une masse de marquage (7, 7', 7") sur un dispositif de réception de substrat (6),
b) mise en contact d'un poinçon de structure (2, 2') avec la masse de marquage (7, 7', 7"),
c) soulèvement au moins partiel de la fixation du substrat (1, 1', 1''),
d) durcissement de la masse de marquage (7, 7', 7"),
f) démoulage de la masse de marquage (7, 7', 7") du poinçon de structure (2, 2'),
dans lequel le poinçon de structure (2, 2') présente un matériau dur transparent aux UV, dans lequel le substrat (1, 1', 1") est flexible et s'adapte ainsi au moins partiellement de manière conforme au poinçon de structure (2, 2') après le soulèvement au moins partiel de la fixation,
dans lequel une épaisseur du substrat (1, 1', 1") est entre 1 µm et 2000 µm, de préférence entre 10 µm et 750 µm, avec une plus grande préférence entre 100 µm et 500 µm.

2. Procédé selon la revendication 1, dans lequel après le soulèvement au moins partiel de la fixation, il se produit un décollement au moins partiel du substrat (1, 1', 1") du dispositif de réception de substrat (6), en particulier par un déplacement relatif du dispositif de réception de substrat (6) et du substrat (1, 1', 1") et/ou par un déplacement relatif du dispositif de réception de substrat (6) et d'un dispositif de réception de poinçon (5, 5') et/ou par des forces capillaires.

3. Procédé selon au moins l'une des revendications précédentes, dans lequel la masse de marquage (7, 7', 7") est structurée sans pression et/ou sans compression, en particulier par des forces capillaires.

4. Procédé selon au moins l'une des revendications précédentes, dans lequel le substrat (1, 1', 1") est fixé sur le dispositif de réception de substrat (6) avec la masse de marquage (7, 7', 7") par au moins un élément de fixation (9, 9') pouvant être commandé et disposé dans le dispositif de réception de substrat (6), en particulier par vide et/ou dépression, et/ou la fixation est levée par l'au moins un élément de fixation (9, 9') pouvant être commandé, en particulier en coupant la dépression et/ou en produisant une surpression.

5. Procédé selon au moins l'une des revendications précédentes, dans lequel la fixation du substrat (1, 1', 1") et le soulèvement au moins partiel de la fixation du substrat (1, 1', 1") s'effectue à un moment défini en particulier en commandant l'au moins un élément de fixation (9, 9') pouvant être commandé, de façon à ce que la structuration de la masse de marquage (7, 7', 7") et/ou la libération, respectivement le décollement du
substrat (1, 1', 1") s'effectue à un moment défini après la mise en contact du poinçon de structure (2, 2') avec la masse de marquage (7, 7', 7'').

6. Procédé selon au moins l'une des revendications précédentes, dans lequel le poinçon de structure (2, 2') est ainsi conçu qu'après le soulèvement au moins partiel de la fixation, la masse de marquage (7, 7', 7") et/ou le substrat (1, 1', 1") sont adaptés conformément au poinçon de structure (2, 2') sans pression externe, en particulier par des forces capillaires.

7. Procédé selon au moins l'une des revendications précédentes, dans lequel le substrat (1, 1', 1") est maintenu par la masse de marquage (7, 7', 7"), en particulier par des forces capillaires, après la mise en contact et/ou après le soulèvement au moins partiel de la fixation.

8. Procédé selon au moins l'une des revendications précédentes, dans lequel les microstructures et/ou nanostructures sont fabriquées en plusieurs couches l'une sur l'autre et/ou l'une à côté de l'autre dans un procédé step and repeat.

9. Procédé selon au moins l'une des revendications précédentes, dans lequel une viscosité de la masse de marquage (7, 7', 7") est inférieure à 100000 cp (100 Pa s), de préférence inférieure à 10000 cp (10 Pa s), de manière plus préférée inférieure à 1000 cp (1 Pa s), de manière la plus préférée inférieure à 500 cp (0,5 Pa s).

10. Procédé selon au moins l'une des revendications précédentes, dans lequel le poinçon de structure (2, 2') présente une structure de marquage (3, 3') et/ou est revêtu d'une structure de marquage (3, 3').

11. Procédé selon au moins l'une des revendications précédentes, dans lequel le poinçon de structure (2, 2') est en verre, quartz ou dioxyde de silicium.
